# EUROPEAN PATENT SPECIFICATION

(11) **EP 3 258 503 B1**
(45) Date of publication and mention of the grant of the patent: **12.04.2023**
(21) Application number: 16180461.2
(22) Date of filing: 20.07.2016
(51) Int. Cl.: H01L 31/048, H01R 4/02, H01L 31/0224, H01L 31/05, H01R 43/02

(54) **HYBRID WEAVE FOR ELECTRICALLY CONTACTING PHOTOVOLTAIC CELLS**
MISCHGEWEBE ZUR ELEKTRISCHEN KONTAKTIERUNG VON PHOTOVOLTAISCHEN ZELLEN
ARMURE HYBRIDE POUR LA MISE EN CONTACT ÉLECTRIQUE DE CELLULES PHOTOVOLTAÏQUES

(30) Priority: 17.06.2016 EP 16175066 P
(43) Date of publication of application: 20.12.2017
(73) Proprietor: IMEC VZW, 3001 Leuven (BE)
(72) Inventor: BORGERS, Tom, 3001 Leuven (BE); GOVAERTS, Jonathan, 3001 Leuven (BE)
(74) Representative: DenK iP bv

(56) References cited:
- WO-A1-2012/173487
- US-A1- 2015 340 529

## Description

### Field of the invention

The present invention relates to the field of photovoltaic cells, e.g. back-contact photovoltaic cells. More in particular, the present invention is related to methods for electrically contacting and encapsulating a back-contact photovoltaic cell, and to methods for interconnecting a plurality of back-contact photovoltaic cells in a photovoltaic module.

### Background of the invention

Various types of back-contact photovoltaic cells, e.g. silicon-based back-contact photovoltaic cells, are known in the art. Such back-contact cells may advantageously achieve a good efficiency by avoiding the use of a conductive contact grid for current collection on the front surface of the cell. Particularly, this potentially higher efficiency than typical for conventional front-contact cells may be explained by a lower self-shading due to absorption and/or reflection of incident radiation on the contact grid. Such efficiency gain may be particularly advantageous in high current cells, e.g. in concentrators or large area modules.

A back-contact back-junction (BC-BJ) cell may have both negative and positive polarity current collection junctions located on the rear surface, e.g. the metallization and the contacted diffused regions may be located solely on the rear surface. Electron-hole pairs generated by light impinging on the front surface can be collected at the rear surface. Since such cells rely upon carrier collection at the rear surface alone, they may preferably have a particularly thin cell substrate of high quality material, e.g. a silicon material of high purity.

In interdigitated back contact (IBC) cells, one such type of back-contact back-junction cell, emitter regions and back-surface field regions and the corresponding contacts of both polarities are provided on the rear surface of the cell, the respective contacts forming an interdigitated finger pattern.

In an emitter wrap-through (EWT) cell, another type of back contact cell, carrier collection occurs at both sides of the cell. The current collection junction on the front surface is wrapped through holes in the silicon substrate by emitter diffusion, e.g. current conduction from the front to the back surface is provided by a plurality of holes or vias through the substrate.

In a similar type of back contact cell, the metal wrap-through (MWT) cell, a metal grid is wrapped from the front surface to the rear surface through a plurality of holes or vias through the substrate. This structure is akin to a conventional cell structure. While the emitter is provided on the front side, busbars are provided on the rear surface, leaving only a thin front surface grid on the illuminated surface that is connected to the rear surface by extending it through a number of metallised openings or vias in the wafer.

In back-contact cells, regardless of the specific type, current is collected at contact points or contact areas on the rear surface, e.g. by soldering connectors to the contact busbars or pads. For example, at least one connector may be soldered to a series of negative polarity contacts and at least one may be soldered to a series of positive polarity contacts. However, since both polarities of a back-contact photovoltaic cell need to be contacted on the rear surface of the cell, e.g. in order to interconnect such back-contact cells in a module, additional electrical insulation may be required. For example, conductors for connecting different polarities might need to cross each other, or a conductor may need to cross an area of a different polarity on the rear surface, such that an insulating layer may be required to avoid short circuiting. The required insulation may be achieved by incorporation of additional materials in the module, such as solder masks, glass fibre and/or polymers. However, such means for providing the necessary insulation can adversely affect the cost and complexity of the module, and may even reduce the reliability.

Methods are known in the art in which back-contact cells are connected into cell strings, followed by a lay-up of the different module layers and string interconnection. Other methods are known in the art, in which all layers are first prepared and then aligned directly on the glass, in an integrated approach. However, solder and/or conductive paste dispensing, punching of insulation layers and the related alignment steps may require multiple cell handling and process steps, which may imply a disadvantageously high cost and complexity, and a reduced processing yield, in particular when considering the trend towards thinner and thus more fragile cells.

In the European patent EP 2660878, a hybrid Leno-woven material made of conductive wires interwoven with insulating wires is disclosed for contacting and/or connecting back-contact photovoltaic cells. The wires are provided using a Leno weaving pattern, in which the conductive wires are used as filling threads in the weft direction and the insulating wires as warp threads, such that the conductive wires remain spatially separated by insulating threads from a cell surface when the material is applied against the surface. However, it is a disadvantage of such approach that separate interconnection and lamination steps may be required.

In US 2015/0340529 A1 (Gillot et al.), an interconnection device for interconnecting back-contact photovoltaic cells in a module is described, which device comprises at least one layer of a fabric woven from electrically insulating fibres comprising at least one portion of a wire or a ribbon in an electrically conductive material woven with the fibres. The portion of the wire or ribbon is arranged for lying flush with the surface of the fabric in at least one region thereof, which region is intended to form an electrical contact are for electrical connection with a contact pad located at the backside of the photovoltaic cell.

Also in this disclosure, a separate encapsulation and interconnection step is generally required and an additional encapsulant material may be necessary which yields sufficient impregnation of the fibre fabric with a given porosity.

The international application WO 2012/173487 A1 (Stichting Onderzoek Centrum Nederland; Cesar Ilkay; Jansen Markus) discloses a method of manufacturing a photovoltaic cell system and the photovoltaic cell system obtainable by such method, in which a connection string with a conductor line and rings of electrically isolating material around the conductor line is provided. Parts of the conductor line are joined to first electrical contact areas of a semiconductor substrate for establishing electrical connections thereto, whereas the rings of electrically isolating material are electrically isolating the conductor line from second electrical contact areas of a semiconductor substrate. A plurality of connection strings with multiple conductor lines and rings of electrically isolating material around the conductor lines may be provided as a woven connector mat.

A disadvantage of such method and manufactured product is that many long metal connection strings are required to connect a photovoltaic cell, which is not very efficient and increases the cost for manufacture. A separate encapsulation step is necessary after soldering of the connection strings to the photovoltaic cell.

### Summary of the invention

It is an object of the present invention to provide good and efficient means and methods for electrically contacting back-contact photovoltaic cells and for electrically connecting back-contact photovoltaic cells.

The above objective is accomplished by a method and device according to the present invention as defined in claim 1 and in claim 14, respectively. The preferred embodiments are set out in the appended set of dependent claims.

It is an advantage of embodiments of the present invention that good, efficient and robust connections between contacts or contact pads of a same polarity of a photovoltaic cell are provided.

It is an advantage of embodiments of the present invention that good, efficient and robust electrical connection of photovoltaic cells having contact pads for both polarities on the same surface, i.e. on the back side, is provided.

It is an advantage of embodiments of the present invention that conductors for connecting such cells are efficiently insulated to prevent short circuiting.

It is an advantage of embodiments of the present invention that back-contact photovoltaic cells can be contacted, e.g. electrically contacted and connected, e.g. electrically connected, using a low cost, simple and reliable method, e.g. using simple and cheap materials.

It is an advantage of embodiments of the present invention that complex cell handling and process steps, such as dispensing solder and/or conductive paste, multiple layer lay-up and multiple alignment steps, can be avoided.

For example, in embodiments of the present invention, photovoltaic cells may be electrically contacted and/or electrically interconnected, without dispensing pastes, e.g. solder and/or conductive paste, and therefore, costs, process steps, cell handling operations, and/or alignment steps related to paste dispensing can be avoided.

For example, in embodiments of the present invention, cell manipulation operations for connecting the cells (e.g. for electrically connecting and encapsulating the cells) can be limited to a single manipulation step for final placement during lay-up.

It is an advantage of embodiments of the present invention that a simple cell handling and processing method for contacting and interconnecting photovoltaic cells is provided that has a low cost and allows a good processing yield.

It is an advantage of embodiments of the present invention that contacts for connecting each of both polarities are provided on a single surface by conductive structures while simultaneously providing insulating, e.g. encapsulating, material.

For example, only a single lay-up step may be required in accordance with embodiments of the present invention for forming electrical contacts for both polarities and for encapsulation, e.g. no separate alignment step is required for insulator and conductor.

For example, separate interconnection steps for soldering or curing can be avoided, e.g. by advantageously providing interconnections simultaneously during a lamination and encapsulation process.

It is an advantage of embodiments of the present invention that electrical connections to the photovoltaic cell can be provided directly by the module encapsulation material, integrated in a woven fabric, to laminate a cell. For example, no intermediate dielectric layers of other materials may be required.

It is an advantage of embodiments of the present invention that solder-coated ribbons can be directly soldered, when provided in a weave, onto cell contact busbars and/or cell contact pads.

It is a further advantage of embodiments of the present invention that the contacting and insulating, e.g. encapsulating, structure provided by embodiments can compensate stresses, e.g. forms an out-of-plane stress relief structure. For example, stresses generated during temperature variations and processing, and/or mechanical stresses on a photovoltaic module can be compensated, e.g. can be absorbed and dispersed efficiently. For example, thermal expansion compensation structures may be provided by embodiments of the present invention, e.g. integrated in the woven fabric.

It is an advantage of embodiments of the present invention that a woven material can be provided for electrically contacting photovoltaic cells that has a simple weave and that can be manufactured and applied in large dimension formats.

It is an advantage of embodiments of the present invention that a woven material can be provided and used that may only contain encapsulant ribbons and conductive connection ribbons.

It is an advantage of embodiments of the present invention that stringing and/or string handling operations can be avoided in forming a photovoltaic module from photovoltaic cells. However, it is an advantage of other embodiments of the present invention that cell stringing can be provided if required, e.g. embodiments of the present invention may be compatible with stringing and string handling.

It is an advantage of embodiments of the present invention that end bussing of cell strings may not be required, e.g. an end bus can be provided in the weave during weaving, e.g. as integral part of the woven fabric.

It is an advantage of embodiments of the present invention that a process in accordance with embodiments can be implemented using few tools and/or machines, and may require only a limited floor space and have a low cost of operation.

It is an advantage of embodiments of the present invention that a back-contact back-junction photovoltaic cell, e.g. an interdigitated back-contact cell, can be manufactured cheaply, e.g. a busbar or part of a busbar as provided in conventional IBC cells can be replaced by an electrically conductive ribbon integrated in a weave or woven fabric in accordance with embodiments. Thus, less metallization on cell level may be required, e.g. less silver metallization.

It is an advantage of embodiments of the present invention that a tapering structure can be provided in a woven fabric, allowing optimization of electrically conductive ribbon cross sections and resistive losses, e.g. to achieve a high fill factor relative to the total cross-section of conductors provided in the weave or woven fabric, and further simplifying the interconnection layout.

In a first aspect, the present invention relates to a method for contacting and electrically connecting at least one back-contact photovoltaic cell. The method comprises providing at least one back-contact photovoltaic cell, wherein said at least one back-contact photovoltaic cell comprises at least a first metal contact of a first polarity and a second metal contact of a second, opposite polarity on a single surface thereof. The method comprises providing a woven fabric comprising a plurality of insulating ribbons, arranged in only a single one direction selected from the group consisting of a warp direction and a weft direction of the woven fabric, and a plurality of conductive wires, arranged in a weft direction or a warp direction or both of the woven fabric, a direction of arrangement of a first plurality of first conductive wires of the plurality of conductive wires being different from the direction of arrangement of the plurality of insulating ribbons, wherein at least one of the plurality of conductive wires comprises at least a first segment and a second segment that are electrically isolated from each other. The method comprises bringing the woven fabric into physical contact with said surface of the at least one back-contact photovoltaic cell. The method comprises performing a heating process to establish an electrical connection between the first metal contact and the first segment and to establish an electrical connection between the second metal contact and the second segment, wherein this heating process furthermore liquefies the plurality of insulating ribbons to transform the plurality of insulating ribbons into an encapsulation layer.

In a method in accordance with embodiments of the present invention, said woven fabric may be provided in the form of a twill weave fabric or a twill-like weave fabric.

In a method in accordance with embodiments of the present invention, said plurality of conductive wires of the woven fabric may comprise copper ribbons coated with a solder material.

In a method in accordance with embodiments of the present invention, said insulating ribbons of said woven fabric may be composed of a transparent material.

In a method in accordance with embodiments of the present invention, providing the woven fabric may comprise weaving the plurality of insulating ribbons and a plurality of conductive wires.

In a method in accordance with embodiments of the present invention, providing the woven fabric may further comprise slitting an insulating foil and/or a conductive foil to respectively form the plurality of insulating ribbons and/or the plurality of conductive wires.

In a method in accordance with embodiments of the present invention, providing the woven fabric may further comprise providing holes in the woven fabric for locally interrupting the at least one of the plurality of conductive wires comprising at least the first segment and the second segment, to thereby electrically disconnect the at least one first segment and the at least one second segment.

In a method in accordance with embodiments of the present invention, providing the at least one back-contact photovoltaic cell may comprise providing a plurality of back-contact photovoltaic cells.

In a method in accordance with embodiments of the present invention, providing the at least one back-contact photovoltaic cell may comprise providing a plurality of emitter wrap-through photovoltaic cells and/or a plurality of metal wrap-through photovoltaic cells.

In a method in accordance with embodiments of the present invention, the first plurality of first conductive wires may comprise each of the at least one of the plurality of conductive wires comprising at least the first segment and the second segment and the first plurality of first conductive wires may be provided, e.g. woven, such that a weave pattern, e.g. a twill pattern, exposes each one of said first conductive wires at a first predetermined location and at a second predetermined location. The first predetermined location corresponds to a location of a metal contact of the first polarity on the single surface of one of the plurality of back-contact photovoltaic cells and the second predetermined location corresponds to a location of a metal contact of the second polarity on the single surface of another one of the plurality of back-contact photovoltaic cells. Each one of said first conductive wires comprising at least the first segment and the second segment is exposed at both the first predetermined location and the second predetermined location on a surface of the woven fabric for contacting the back-contact photovoltaic cells.

In a method in accordance with embodiments of the present invention, each one of said first conductive wires comprising at least the first segment and the second segment may cross over at least one insulating ribbon of the plurality of insulating ribbons in between the first predetermined location and the second predetermined location to be exposed at a surface of the woven fabric opposite of the surface for contacting the back-contact photovoltaic cells.

In a method in accordance with embodiments of the present invention, said first segment of the at least one conductive wire of the plurality of conductive wires comprising at least the first segment and the second segment may comprise the first predetermined location and said second segment of the at least one conductive wire of the plurality of conductive wires comprising at least the first segment and the second segment may comprise the second predetermined location. Said first segment and said second segment of the at least one conductive wire of the plurality of conductive wires comprising at least the first segment and the second segment are disconnected from each other by a hole interrupting the at least one conductive wire comprising at least the first segment and the second segment, the hole being provided where said at least one conductive wire comprising at least the first segment and the second segment crosses over the at least one insulating ribbon of the plurality of insulating ribbons in between the first predetermined location and the second predetermined location to be exposed at a surface opposite of the surface for contacting the back-contact photovoltaic cells.

In a method in accordance with embodiments of the present invention, the woven fabric may comprise two string end busbars that are interwoven at opposite ends of the first plurality of first conductive wires, each string end busbar comprising a further conductive wire arranged on, and oriented along, a corresponding one insulating ribbon of the plurality of insulating ribbons, such that electrical contacts are established between the first segments of the at least one conductive wire comprising at least the first segment and the second segment and the first string end busbar and electrical contacts are established between the second segments of the at least one conductive wire comprising at least the first segment and the second segment and the second string end busbar.

In a method in accordance with embodiments of the present invention, providing the at least one back-contact photovoltaic cell may comprise providing a plurality of interdigitated back-contact photovoltaic cells.

In a method in accordance with embodiments of the present invention, the woven fabric may comprise a second plurality of second conductive wires arranged in the direction of the woven fabric in which the plurality of insulating ribbons is arranged, wherein each one of the second plurality of second conductive wires is arranged on a corresponding one insulating ribbon of the plurality of insulating ribbons and oriented along a central longitudinal axis thereof.

In a method in accordance with embodiments of the present invention, the woven fabric may have a weave pattern, e.g. a twill weave fabric having a twill weave pattern, in which at least part of the first plurality of first conductive wires are double weft per pick such as to form a plurality of aligned pairs of first conductive wires.

In a method in accordance with embodiments of the present invention, the weave pattern, e.g. a twill weave pattern, of the woven fabric may, for at least one pair of the plurality of aligned pairs of first conductive wires, e.g. for each aligned pair, expose one of the first conductive wires of that pair of the at a first predetermined location, and expose the other one of the first conductive wires of that pair at a second predetermined location on a surface of the woven fabric for contacting the back-contact photovoltaic cells. The first predetermined location corresponds to the location of the first metal contact on the single surface one of the plurality of back-contact photovoltaic cells and the second predetermined location corresponds to a location of the second metal contact on the single surface of the same one of the plurality of back-contact photovoltaic cells.

In a method in accordance with embodiments of the present invention, said first conductive wires of the at least one pair of the plurality of aligned pairs of first conductive wires may cross over a same one of the plurality of insulating ribbons and its corresponding second conductive wire of the second plurality of second conductive wires such to form electrical connections between respectively one of the conductive wires of said at least one pair of the plurality of aligned pairs of first conductive wires and said first segment and said other one of the conductive wires of said at least one pair of the plurality of aligned pairs of first conductive wires and said second segment, wherein the first segment and the second segment are segments of said corresponding second conductive wire of the second plurality of second conductive wires.

In a method in accordance with embodiments of the present invention, said first segment and said second segment of the corresponding second conductive wire may be disconnected from each other by a hole interrupting said corresponding second conductive wire of the second plurality of second conductive wires, the hole being provided in between said first conductive wires of said at least one pair of the plurality of aligned pairs of first conductive wires

In a method in accordance with embodiments of the present invention, providing the at least one back-contact photovoltaic cell may comprise providing a busbar-less interdigitated back-contact photovoltaic cell, wherein said first metal contact and said second metal contact correspond to opposite polarity regions of fingers formed on the busbar-less interdigitated back-contact photovoltaic cell.

In a method in accordance with embodiments of the present invention, providing said busbar-less interdigitated back-contact photovoltaic cell may comprise providing said photovoltaic cell comprising local interconnections for forming interconnecting bridges between fingers corresponding to the same charge polarity over regions where the first plurality of first conductive wires of the woven fabric, when contacted to the photovoltaic cell, are woven such that the weave pattern, e.g. twill pattern, exposes the first plurality of first conductive wires at the surface of the woven fabric opposite of the surface for contacting the at least one back-contact photovoltaic cell.

In another aspect, the present invention relates to a woven fabric for use in a method according to embodiments of the first aspect of the present invention, the woven fabric comprising a plurality of insulating ribbons, arranged in only a single one direction selected from the group consisting of a warp direction and a weft direction of the woven fabric, and a plurality of conductive wires, arranged in a weft direction or a warp direction or both of the woven fabric, a direction of arrangement of a first plurality of first conductive wires of the plurality of conductive wires being different from the direction of arrangement of the plurality of insulating ribbons, wherein at least one of the plurality of conductive wires comprises at least a first segment and a second segment that are electrically isolated from each other.

In another aspect, the present invention also relates to a photovoltaic module comprising a plurality of back-contact photovoltaic cells and a woven fabric according to embodiments of the second aspect, wherein each of said plurality of back-contact photovoltaic cells comprises at least a first metal contact of a first polarity and a second metal contact of a second, opposite polarity on a single surface thereof, wherein said plurality of back-contact photovoltaic cells are contacted and electrically connected by said woven fabric, wherein said woven fabric is in physical contact with said surfaces of the plurality of back-contact photovoltaic cells, wherein an electrical connection between the first metal contact and the first segment and an electrical connection between the second metal contact and the second segment are established, and wherein the plurality of insulating ribbons are at least partially molten over an area of physical contact between said woven fabric and said surfaces of the plurality of back-contact photovoltaic cells to form an encapsulation layer.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG 1 illustrates a first exemplary woven fabric relating to embodiments of the present invention.
FIG 2 illustrates a back surface of a photovoltaic cell for use in a method in accordance with embodiments of the present invention.
FIG 3 illustrates a step of bringing a woven fabric into physical contact with a back surface of two back-contact photovoltaic cells, in accordance with embodiments of the present invention.
FIG 4 illustrates a step of providing two photovoltaic cells and a woven fabric in accordance with embodiments of the present invention between two glass plates.
FIG 5 illustrates an arrangement of string end-busbars for terminating cell strings in accordance with embodiments of the present invention.
FIG 6 illustrates a second exemplary woven fabric relating to embodiments of the present invention.
FIG 7 shows a back surface of an interdigitated back-contact photovoltaic cell for use in a method in accordance with embodiments of the present invention.
FIG 8 shows a step of bringing a woven fabric into physical contact with a back surface of an interdigitated back-contact photovoltaic in accordance with embodiments of the present invention.
FIG 9 shows a back surface of a busbar-less interdigitated back-contact photovoltaic cell relating to embodiments of the present invention.
FIG 10 illustrates alignment and contacting steps for joining a busbar-less interdigitated back-contact photovoltaic cell and a woven fabric in accordance with embodiments of the present invention.
FIG 11 shows a cross section of an exemplary woven fabric related to embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In the context of the present invention, the front surface or front side of a photovoltaic cell or of a photovoltaic module is the surface or side adapted for being oriented towards a light source and thus for receiving illumination. In case of bifacial photovoltaic cells or modules, both surfaces are adapted to receive impinging light. In such case, the front surface or front side is the surface or side adapted for receiving the largest fraction of the light or illumination. The back surface, rear surface, back side or rear side of a photovoltaic cell or a photovoltaic module is the surface or side opposite to the front surface or side.

In the context of the present invention, a busbar is an electrically conductive strip for collecting an electrical current, e.g. a current generated under illumination, from a plurality of metal contacts or metal electrodes provided on a surface of a photovoltaic cell. A busbar is provided for direct electrical connection with an external electrical lead. A busbar typically collects the electrical current from finer or narrower metal contacts, also called metal fingers, on the cell. These finer or narrower metal contacts collect an electrical current from the cell and deliver the current to the busbars; they are typically not provided for direct electrical connection to an external electrical lead.

In the context of the present invention a busbar-free photovoltaic cell is a photovoltaic cell not having busbars. A busbar-free photovoltaic cell typically comprises a plurality of metal contacts or metal electrodes on a surface of the cell but after cell fabrication it does not comprise an electrically conductive element for collecting current from the plurality of metal contacts. After finishing the cell processing, for example during module fabrication, electrically conductive elements such as for example electrically conductive wires are soldered to the plurality of metal contacts. These electrically conductive elements are provided for collecting an electrical current from the plurality of metal electrodes and they replace the conventional busbars.

In the context of embodiments of the present invention, a twill fabric or a twill weave is a weave wherein one or more weft yarns (or warp yarns) alternately pass over and under two or more warp yarns (or weft yarns respectively) in a regular repeated manner, with a step or offset between rows. Twill weave is a basic weave characterized by pronounced diagonal ridges, called twill lines. The construction of a twill weave may be identified by a fraction, in which the numerator indicates the number of warp threads crossing over a number of weft threads as indicated in the denominator. For example, for an uneven 3/1 ratio twill, the warp wire may sequentially be crossing over three weft wires and under one weft wire.

In a first aspect, the present invention relates to a method for contacting at least one back-contact photovoltaic cell, e.g. electrically contacting at least one back-contact photovoltaic cell. The present invention further relates to a method for electrically interconnecting a plurality of back-contact photovoltaic cells, for example to form a photovoltaic module. It is an advantage of embodiments of the present invention that a substantially monolithic module-level integration of photovoltaic cells can be achieved using simple and cost-efficient techniques.

The method comprises providing at least one back-contact photovoltaic cell. This at least one back-contact photovoltaic cell comprises at least one first metal contact of a first polarity and at least one second metal contact of a second polarity, opposite to the first polarity, on a surface of the cell, i.e. on the same surface, e.g. back surface, of the cell. The back-contact photovoltaic cell, e.g. the plurality of back-contact photovoltaic cells, may for example comprise an emitter wrap-through (EWT) or metal wrap-through (MWT) back-contact photovoltaic cell. The back-contact photovoltaic cell, e.g. the plurality of back-contact photovoltaic cells, may comprise a back-contact back-junction (BC-BJ) photovoltaic cell, e.g. an interdigitated back-contact (IBC) photovoltaic cell, the present invention not being limited thereto.

The method comprises providing a woven fabric. The woven fabric may be a twill weave fabric, or a twill-like weave fabric, e.g. a fabric woven by a weaving technique derived from a twill weave, e.g. a combination twill weave or pointed twill weave, the present invention not being limited thereto.

The woven fabric comprises a plurality of electrically insulating ribbons arranged in only a single one direction selected from the group consisting of a warp direction and a weft direction of the woven fabric, and a plurality of electrically conductive wires arranged in a weft direction or a warp direction or both of the woven fabric, a first plurality of first electrically conductive wires being arranged in a direction different from the direction in which the plurality of insulating ribbons is arranged.

For example, the woven fabric may comprise a first plurality of first electrically conductive wires, the first plurality of first electrically conductive wires being arranged in a direction different from the direction in which the plurality of insulating ribbons is arranged, and such woven fabric may e.g. comprise no electrically conductive wires arranged in the direction in which the plurality of insulating ribbons is arranged.

For example, alternatively the woven fabric may comprise a first plurality of first electrically conductive wires, the first plurality of first electrically conductive wires being arranged in a direction different from the direction in which the plurality of insulating ribbons is arranged, and the woven fabric may further comprise a second plurality of second electrically conductive wires, the second plurality of second electrically conductive wires being arranged in a direction corresponding to the direction in which the plurality of insulating ribbons is arranged.

In advantageous embodiments the woven fabric comprises a plurality of electrically insulating ribbons arranged in a warp direction of the woven fabric, and a plurality of electrically conductive wires arranged in at least a weft direction of the woven fabric. For example, in such embodiments the woven fabric may comprise a first plurality of first electrically conductive wires arranged in a weft direction, and the woven fabric may e.g. comprise no electrically conductive wires arranged in a warp direction. For example, alternatively, in such embodiments the woven fabric may comprise a first plurality of first electrically conductive wires arranged in a weft direction and the woven fabric may further comprise a second plurality of second electrically conductive wires arranged in a warp direction. It is an advantage of embodiments having the electrically insulating ribbons being arranged in a warp direction that it may allow easier or faster fabrication (weaving) of the woven fabric as compared to embodiments wherein the electrically insulating ribbons are arranged in a weft direction.

The further description relates to embodiments wherein the electrically insulating ribbons are provided in a warp direction of the woven fabric. However, the present invention in not limited thereto and it also includes embodiments wherein the electrically insulating ribbons are provided in a weft direction of the woven fabric.

The electrically conductive wires may comprise electrically conductive ribbons. The conductive wires, e.g. ribbons, may thus be secured in the woven fabric by weaving them with the electrically insulating ribbons.

The electrically conductive wires may comprise a metal, e.g. a low-resistance metal, such as copper, aluminum, gold or silver. For example, the electrically conductive wires may comprise copper ribbons. Furthermore, the electrically conductive wires may be coated with a solderable material, e.g. a solder. For example, the electrically conductive wires may comprise solder-coated copper ribbons. The conductive wires may be coated with a low temperature solder material, e.g. a solder alloy for soldering at a temperature in the range of 20°C and 300°C, e.g. in the range of 50°C and 150°C, e.g. in the range of 60°C and 100°C. For example, a solder alloy comprising Ag, Bi, Sn, Pb, Cd, Zn or In may be used, the present invention not being limited thereto.

The electrically insulating ribbons may be made of a polymer, e.g. a polymer suitable for photovoltaic encapsulation purposes. The insulating ribbons may be composed of a thermoplastic polymer and/or of a polymer that allows ensuring sufficient structural and electrical separation and insulation between the electrically conductive wires before, during and after lamination. For example, the insulating ribbons may comprise a polyolefin encapsulant material, or an EVA (ethylene vinyl acetate) encapsulant material or a multi-layer material such as for example an EVA/polyolefin/EVA stack, the present invention not being limited thereto.

The electrically insulating ribbons may be transparent, or may be adapted for transforming into a transparent material by liquefaction and subsequent solidification into the encapsulation layer referred to further hereinbelow. For example, such transparency may be advantageous for use in double glass building-integrated photovoltaic modules, e.g. with large spacing between cells, to allow sufficient light to pass through the module for indoor lighting purposes and/or for a substantially unobstructed view through the module. Alternatively, the electrically insulating ribbons may be coloured, e.g. to hide the conducting wires between the cells, for example for aesthetical reasons.

The electrically insulating ribbons may furthermore be relatively wide, e.g. wider than the second electrically conductive ribbons or wires, which are arranged in the same direction as the electrically insulating ribbons, such as for example more in particular in the warp direction. The electrically insulating ribbons may be e.g. at least twice as wide, e.g. at least thrice as wide, for example at least five times as wide, as compared to the second electrically conductive ribbons or wires, such as to allow a good lateral insulation of adjacent electrically conductive wires in the weft direction and to allow - where required - a good insulation in a direction orthogonal to the plane of the woven fabric between a first electrically conductive ribbon arranged in the weft direction and a crossing second electrically conductive ribbon arranged in the warp direction. However, at predetermined locations an intentional electrical connection or an intentional electrical contact can be provided between electrically conductive wires, e.g. between a first electrically conductive wire and a crossing second electrically conductive wire, as will be described further hereinbelow. For example, the insulating ribbons, e.g. insulating polymer ribbons, may have a width of at least 3 mm, e.g. at least 5 mm, for example 7.5 mm, or even more, e.g. 1 cm, or a width in the range of 3 mm to 3 cm, the present invention not being limited thereto. For example, a width of 7.5 mm could correspond to about 20 insulating ribbons to cover a cell of about 15 cm. On the other hand, the second electrically conductive wires may for example comprise a conductive ribbon of 1 mm width, e.g. in the range of 500 µm to 5 mm, e.g. in the range of 750 µm to 2 mm, the present invention not being limited thereto. The first electrically conductive wires may for example have a width in the same range or in the same order as the second electrically conductive wires or they may have a different width, e.g. a larger width. The electrically conductive ribbons may for example have a height or thickness in the range of 10 µm to 200 µm, e.g. in the range of 40 µm to 120 µm, e.g. 70 µm, the present invention not being limited thereto. The electrically insulating ribbons may for example have a height or thickness the range between 100 µm to 1 mm, e.g. in the range between 200 µm and 600 µm, such as e.g. in the order of 400 µm, the present invention not being limited thereto.

In a method in accordance with embodiments of the present invention, providing the woven fabric may comprise a step of weaving the plurality of insulating ribbons and the plurality of electrically conductive wires. In other embodiments, the woven fabric may be obtained as a pre-woven fabric.

The electrically insulating ribbons and/or the electrically conductive ribbons may for example be obtained by slitting respectively an insulating foil, e.g. an encapsulant foil, and a conductive foil, e.g. a metal foil, such as a copper foil. Then, the slits or slitted parts of the insulating foil (the insulating ribbons) and the slits or slitted parts of the conductive foil (the conductive ribbons) may be woven to form the woven fabric. Next a heating step may be performed, for example comprising heating to a temperature lower than the melting temperature of the electrically insulating ribbons, such as for example to a temperature in the range between 90°C and 110°C, at which the electrically insulating material becomes sticky. Such heating step may advantageously result in a fixation of the electrically insulating ribbons and the electrically conductive ribbons within the fabric. Thus, providing the woven fabric may comprise slitting an insulating foil and/or a conductive foil to respectively form the plurality of insulating ribbons and/or the plurality of conductive wires (in the form of conductive ribbons).

The weaving pattern of the insulating ribbons and conductive wires, e.g. a twill or twill-like weave pattern, may expose the first electrically conductive wires arranged in the weft direction to both sides of the woven fabric, i.e. at some locations the first electrically conductive wires may be exposed at a first side of the woven fabric and at other locations the first electrically conductive wires may be exposed at a second, opposite, side of the woven fabric. Thus, at least part of the first electrically conductive wires arranged in the weft direction that is exposed at a side for contacting the photovoltaic cell may be electrically connectable to contact pads or busbars of the photovoltaic cell, e.g. by soldering. In embodiments wherein busbar-less photovoltaic cells are electrically contacted and/or electrically connected by a woven fabric according to embodiments of the present invention, first electrically conductive wires may replace the busbars or cell string interconnections, e.g. they may have the function of a busbar or of a string interconnection.

Further hereinbelow, "contact side" or "first side of the woven fabric" will refer to the side of the woven fabric that is intended to be directly contacted to the photovoltaic cell in accordance with a method of embodiments of the present invention, while "non-contact side" or "second side of the woven fabric" will refer to the opposite side that is not intended to be directly contacted to the photovoltaic cell in a method in accordance with embodiments of the present invention. However, this naming convention should not be construed as implying any other properties of or differences between these opposite sides of the woven fabric. For example, the "contact side" may equally refer to the a side of the woven fabric at a moment in time where no contact is not yet established with this side, and the "non-contact side" is nonetheless contactable by arbitrary means, yet not intended to directly and physically contact the photovoltaic cell in accordance with embodiments of the present invention.

At least one of the plurality of electrically conductive wires comprises, e.g. is divided into, at least a first segment and a second segment that are electrically insulated from each other, e.g. to electrically isolate two distinct end regions of the wire in the warp or weft direction. For example, providing the woven fabric may comprise providing holes in the woven fabric for locally severing or separating the at least one first segment and the at least one second segment. For example, in a woven fabric in accordance with embodiments of the present invention, at least one of, for example a plurality of, e.g. each one of, the first electrically conductive wires may comprise, e.g. may be divided into, at least a first segment and a second segment that are electrically insulated from each other. For example, in a woven fabric in accordance with embodiments of the present invention wherein the woven fabric comprises second electrically conductive ribbons arranged in the warp direction, at least one of, for example a plurality of, e.g. each one of, the second electrically conductive wires may comprise, e.g. may be divided into, at least a first segment and a second segment that are electrically insulated from each other.

For example, in the woven fabric, a hole may be provided to locally sever or interrupt at least one of the plurality of electrically conductive wires. Such hole may, for example, be provided in a part of the electrically conductive wire that is exposed at a surface of the woven fabric opposite of the surface that will be used for contacting the photovoltaic cell, as described further hereinbelow, the present invention not being limited thereto. Furthermore, the hole may also penetrate the insulating ribbon where the conductive wire is supported by the insulating ribbon. For example, the diameter, e.g. a width and/or height, of the hole may be less than the width of the insulating ribbon, yet at least as wide as the conductive wire.

The method further comprises bringing the woven fabric into physical contact with a surface of the at least one back-contact photovoltaic cell where the electrical contacts of the cell are located, e.g. with corresponding surface sides of the plurality of back-contact photovoltaic cells, e.g. with the back surface of the at least one back-contact photovoltaic cell. The at least one back-contact photovoltaic cell comprises, on this surface for contacting the woven fabric, at least one first metal contact of a first polarity and at least one second metal contact of a second polarity opposite to the first polarity.

The method also comprises performing a heating process for establishing an electrical connection between a first metal contact and a first electrically conductive wire oriented in the weft direction to form a conductive path between the first metal contact and a first segment, and to establish an electrical connection between a second metal contact and a first electrically conductive wire oriented in the weft direction to form a conductive path between the second metal contact and a second segment. The first segment and the second segment may thus be adapted for collecting a current from the first and second metal contacts respectively by the electrical connections formed in this step of performing a heating process.

Furthermore, this heating process is also adapted for liquefying, e.g. melting, the plurality of insulating ribbons, e.g. polymer ribbons, to transform these insulating ribbons into an encapsulation layer. By liquefying the insulating ribbons, a uniform ribbon and encapsulant composite may be created, while keeping the conductive wires separated or contacted as intended by the structure of the weave. By providing sufficient insulating ribbons in the woven fabric, a layer of encapsulation material may be formed on the backside of the back-contact cells that is sufficient for the cell encapsulation, i.e. such that there is no need for providing additional encapsulation material or an additional encapsulation layer at the back side of the cells when performing a cell encapsulation process.

A connection soldering step of the conductive wires, e.g. conductive ribbons, to the contacts of the cell, and of crossing contacting ribbons in the weave, can thus be advantageously combined with an encapsulation step.

Furthermore, the method in accordance with embodiments may also comprise contacting at least one conductive wire, e.g. the first segment and/or the second segment, e.g. on a part thereof that is exposed on the side that is opposite of the side contacting the cell, by at least one module terminal to form an electrical connection. Since the conducting wires are contactable on both sides of the woven fabric, connection of module terminals can be done during the encapsulation process.

The photovoltaic cell, e.g. the plurality of photovoltaic cells, may comprise a back-contact back-junction (BC-BJ) photovoltaic cell, e.g. an interdigitated back-contact (IBC) photovoltaic cell. For example, the first segment and the second segment may be electrically connected to the first and the second metal contact respectively such as to collect a current from the back side of the BC-BJ photovoltaic cell, e.g. from IBC cell busbars or contact pads.

The method may furthermore comprise aligning the at least one back-contact photovoltaic cell and the woven fabric, e.g. prior to bringing the woven fabric into contact with the back-contact photovoltaic cell, such as to align the second metal contact with the second segment and the first metal contact with the first segment.

In a second aspect, the present invention also relates to a woven fabric for use in a method in accordance with embodiments of the first aspect of the present invention. For example, embodiments of the present invention may relate to a woven fabric for use in a method according to embodiments of the first aspect of the present invention. In the embodiments described below, the woven fabric comprises a plurality of insulating ribbons arranged in a warp direction of the woven fabric, and a plurality of conductive wires arranged in at least a weft direction of the woven fabric, wherein at least one of the plurality of conductive wires comprises at least a first segment and a second segment that are electrically isolated from each other. However, the present invention is not limited thereto and in other embodiments of the present invention the woven fabric may comprise a plurality of insulating ribbons arranged in a weft direction of the woven fabric and a plurality of conductive wires arranged in at least a warp direction of the woven fabric, wherein at least one of the plurality of conductive wires comprises at least a first segment and a second segment that are electrically isolated from each other.

In a further aspect, the present invention also relates to a photovoltaic module obtainable by interconnecting a plurality of photovoltaic cells in accordance with a method according to embodiments of the first aspect of the present invention.

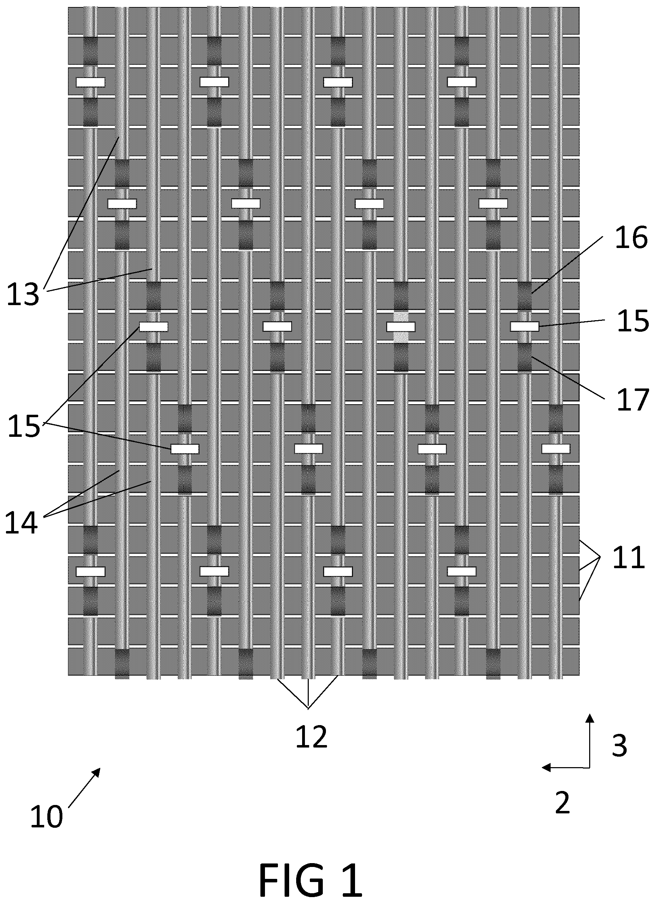

FIG 1 illustrates a first exemplary woven fabric 10 in accordance with embodiments of the present invention, e.g. for use in a method in accordance with embodiments of the present invention. More in particular, the woven fabric 10 illustrated in FIG 1 comprises a plurality of electrically insulating ribbons 11 in a warp direction and a first plurality of first electrically conductive ribbons 12 in a weft direction. In does not contain second electrically conductive ribbons in the warp direction. However, as further described, it may comprise electrically conductive string end-busbars being provided in the warp direction. The first electrically conductive ribbons 12 are interrupted at predetermined locations, e.g. by stamping, punching or cutting a hole 15, such that the first electrically conductive ribbons 12 comprise, e.g. are divided into, at least a first segment 13 and a second segment 14 that are electrically insulated from each other.

This woven fabric 10 may form, after application of the heating process in accordance with a method of embodiments of the present invention, an encapsulant sheet with integrated interconnections, for use in contacting and electrically connecting back-contact photovoltaic cells. More in particular, this exemplary woven fabric 10 may be used for electrically contacting and electrically connecting, e.g. interconnecting, back-contact cells such as metal wrap-through or emitted wrap-through cells, e.g. a back-contact cell in which no busbar metallization is provided nor required on the back surface of the photovoltaic cell.

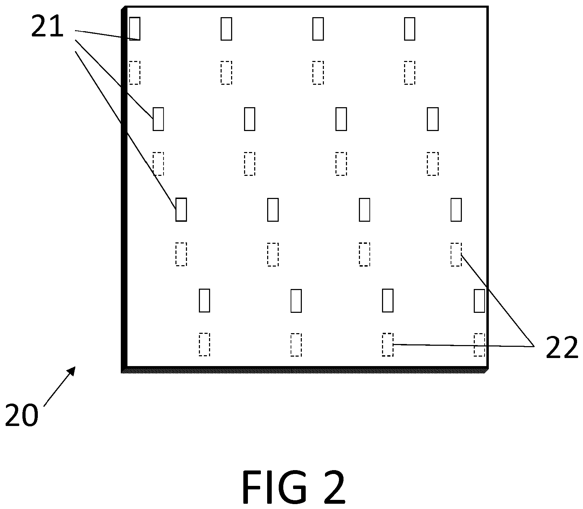

FIG 2 illustrates, schematically, a back surface of such an exemplary back-contact photovoltaic cell 20, e.g. a metal wrap-through cell, for use in combination with an exemplary woven fabric 10 in accordance with embodiments of the present invention as shown in FIG 1. The back-contact photovoltaic cell 20 comprises, on the surface for contacting the woven fabric, e.g. on the rear surface opposite of the front surface for being oriented to a source of illumination in operation of the cell, at least one first metal contact 21 and at least one second metal contact 22 of opposite polarity with respect to the first metal contact. For example, a plurality of first metal contacts 21 may consist of contact pads operably connected via wrap-through connections to a front-side grid of the cell, e.g. for providing emitter contacts to the cell, and the plurality of second metal contacts 22 may consist of contact pads to regions of opposite polarity at the backside of the cell, e.g. for providing base contacts or back surface field contacts to the cell.

The exemplary woven fabric 10, in accordance with embodiments of the present invention, comprises a plurality of electrically insulating ribbons 11 arranged in a warp direction 2 of the woven fabric. The woven fabric 10 also comprises a first plurality of first electrically conductive wires 12, arranged in the weft direction 3 of the woven fabric.

The woven fabric 10 may be a twill or twill-like weave fabric, e.g. a combination twill or a pointed twill weave pattern. This twill or twill-like pattern may advantageously implement a tapering design, as will be described hereinbelow.

For example, the first plurality of first conductive wires 12 may be woven such that the weave pattern, e.g. a twill pattern, exposes the conductive wire at a surface for contacting the photovoltaic cell at a first predetermined location 16 corresponding to a location of the first metal contact 21 of the photovoltaic cell 20, and for exposing the first conductive wire at this surface for contacting at a second predetermined location 17 corresponding to a location of the second metal contact 22 of the back-contact photovoltaic cell 20. In between such contact-side first and second predetermined locations 16 and 17, at least one pick on the opposite side of the fabric 10 may be provided in the first conductive wire 12, e.g. the first conductive wire 12 crosses over at least one insulating ribbon 11 to be exposed at the non-contact side in between the first predetermined location 16 and the second predetermined location 17. For example, in the exemplary woven fabric 10 shown in FIG 1, two picks of the first conductive wires 12 are provided on the contact side of the fabric 10 and all other picks of the first conductive wires are provided on the non-contact side. For each first conductive wire 12 one pick is provided on the non-contact side in between the first predetermined location 16 and the second predetermined location 17. However, the weave configuration, e.g. the twill ratio or twill combination configuration, may be selected based on the layout of the contacts to be contacted on the back-contact photovoltaic cell 20, as will be readily understood to the skilled person.

At least one of the first plurality of first electrically conductive wires 12 comprises at least a first segment 13 and a second segment 14 that are electrically insulated from each other, e.g. by a hole 15 separating the first segment 13 from the second segment 14. For example, most of, e.g. each of, the first conductive wires 12 may be severed or interrupted by a corresponding hole 15 provided through the first conductive wire 12 and the insulating ribbon 11 directly underneath. Such hole may be provided by stamping or locally cutting the first conductive wire 12, e.g. stamping or cutting the first conductive wire and the overlapping part of the insulating ribbon. However, preferably, the width of the hole 15 may be smaller than the width of the insulating ribbon, e.g. such as to maintain a structural integrity provided by the warp oriented ribbon.

The first segment 13 may comprise the first predetermined location 16, and the second segment 14 may comprise the second predetermined location 17. Thus, a hole 15, or a different type of electrical interruption for at least electrically disconnecting the first segment from the second segment, may be provided in between the contact-side first predetermined location 16 and the contact-side second predetermined location 17, e.g. in at least one pick of the first conductive wire 12 on the non-contact side of the fabric 10.

The electrical interruptions, e.g. holes 15, may be provided in each first conductive wire 12 at a fixed position with respect to the twill-like weave pattern, e.g. at a fixed pick in the pick sequence. Due to a fixed offset of the weave pattern, e.g. the pick pattern, in one first conductive wire with respect to a next first conductive wire, the electrical interruptions may form a tapered structure in the woven fabric. For example, each wire may provide a segment for contacting a negative polarity contact of the photovoltaic cell at one end and a segment for contacting a positive polarity contact of the photovoltaic cell at the other end.

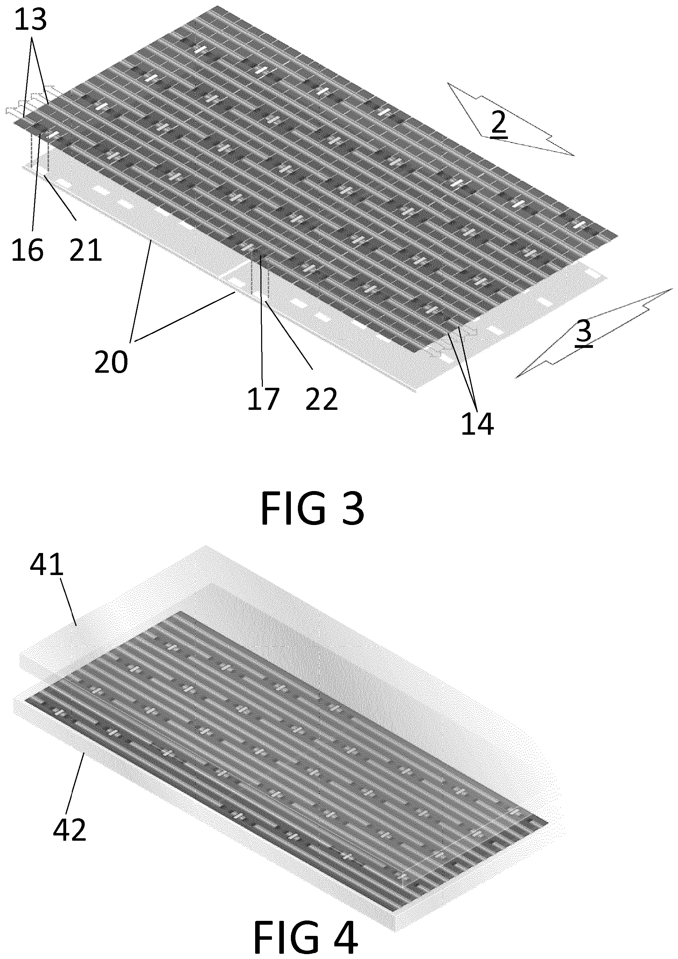

The step of bringing the woven fabric 10 into physical contact with a surface of the at least one back-contact photovoltaic cell 20, e.g. with the back side of two back-contact photovoltaic cells 20, is illustrated in FIG 3. A method in accordance with embodiments of the present invention may comprise aligning the at least one back-contact photovoltaic cell 20 and the woven fabric 10, e.g. prior to bringing the woven fabric into contact with the back-contact photovoltaic cell, such as to align the first predetermined location 16 with a location of the first metal contact 21 on the back-contact photovoltaic cell 20, and to align the second predetermined location 17 with a location of the second metal contact 22.

Thus, after contacting, first segments 13 of the first electrically conductive wires 12 may be electrically connected to the photovoltaic cells to carry a first charge polarity, e.g. connected to '-' terminals, and second segments 14 of the first electrically conductive wires 12 may be electrically connected to the photovoltaic cells to carry a second charge polarity opposite to the first charge polarity, e.g. connected to '+' terminals.

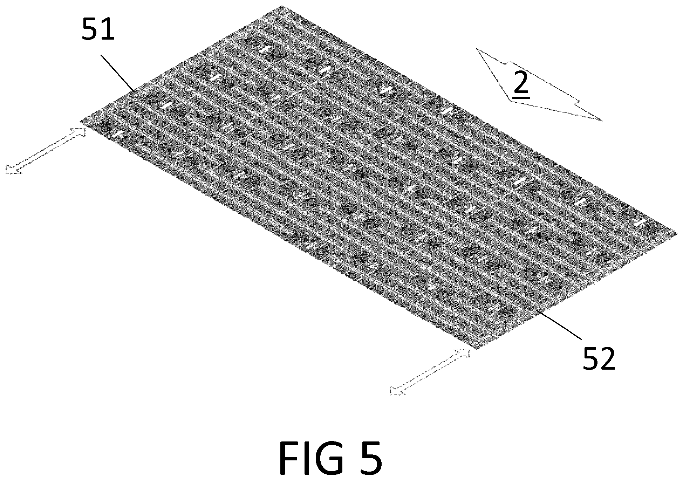

Furthermore, in embodiments according to the present invention, string end-busbars may be interwoven at the end of a cell string. For example, as illustrated in FIG 5, the first segments 13 of the conductive wires that are electrically connected to the photovoltaic cells to carry a first charge polarity, e.g. connected to '-' terminals, may electrically contact a first string end busbar 51, e.g. provided on the 'non-contact' side of an insulating ribbon 11, i.e. on the side of the insulating ribbon that is facing away from the photovoltaic cell. The first segments 13 of the first conductive wires 12 are woven such as to be exposed at the 'non-contact' side of the fabric 10, thus enabling contacting the first string end busbar 51. Likewise, the second segments 14 of the first conductive wires that are electrically connected to the photovoltaic cells to carry a second charge polarity opposite to the first charge polarity, e.g. connected to '+' terminals, may electrically contact a second string end busbar 52, in the same manner as discussed hereinabove for the first segments 13 in relation to the first string end busbar 51.

These string end busbars 51, 52 may extend or connect to similar busbars of adjacent cells. For example, adjacent to the woven fabric 10, in the warp direction 2, another similar or identical woven fabric 10 connected to back-contact photovoltaic cells 20 may be provided. However, the cells in the neighbouring string may be rotated 180°, such as to reverse the polarities of the string end busbars at corresponding ends of the adjacent fabrics. This enables a connection of positive to negative terminals of adjacent cell strings via extension and/or interconnection of the string end busbars 51, 52, e.g. such as to form a series interconnection between cell strings.

Then, as illustrated in FIG 4, the back-contact photovoltaic cell or a plurality of back-contact photovoltaic cells (an example with two back-contact photovoltaic cells 20 being illustrated in FIG 4) may be provided on, e.g. laid on, a transparent front carrier 42 such as a glass plate, with a front side of the photovoltaic cells being oriented towards the front carrier 42, afterwards the woven fabric 10 may be provided on, e.g. laid on, the photovoltaic cells and aligned with the photovoltaic cells, and a back carrier 41, e.g. a further glass plate or backsheet, may be provided on, e.g. laid on, the woven fabric, in view of forming an encapsulated photovoltaic module. In between the transparent front carrier 42 and the back-contact photovoltaic cells 20 an encapsulant, e.g. a transparent encapsulant, may be provided. In between the back carrier 41 and the photovoltaic cells, the material of the insulating ribbons may function as an encapsulant. The amount of encapsulation material provided by the insulating ribbons 11 may be sufficient, i.e. there may be no need for providing additional encapsulation material or an additional encapsulation layer. Next a heating process is performed, thereby transforming the material of the electrically insulating ribbons into an encapsulant layer, e.g. by liquefying the insulating ribbons. Simultaneously, by performing the heating process in a method in accordance with embodiments of the present invention, the back-contact photovoltaic cells 20 are electrically connected and physically bonded to the woven fabric 10.

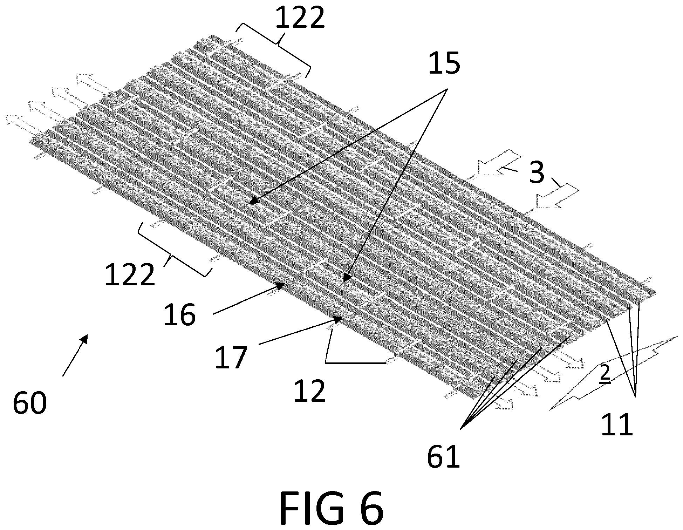

FIG 6 illustrates a second exemplary woven fabric 60 in accordance with embodiments of the present invention, e.g. for use in a method in accordance with embodiments of the present invention. This woven fabric 60 may form, after application of the heating process in accordance with a method of embodiments of the present invention, an encapsulant sheet with integrated interconnections, for use in contacting and electrically connecting back-contact photovoltaic cells, e.g. back-contact back-junction (BC-BJ) cells. More in particular, this exemplary woven fabric 60 may be used for electrically contacting and electrically connecting, e.g. interconnecting, interdigitated back-contact (IBC) cells, e.g. a back-contact cell in which an interdigitated finger pattern is formed on the back surface of the photovoltaic cell. The second exemplary woven fabric 60 shown in FIG 6 comprises a plurality of electrically insulating ribbons 11 arranged in the warp direction 2, a first plurality of first electrically conductive ribbons 12 arranged in the weft direction 3, and a second plurality of second electrically conductive ribbons 61 arranged in the warp direction.

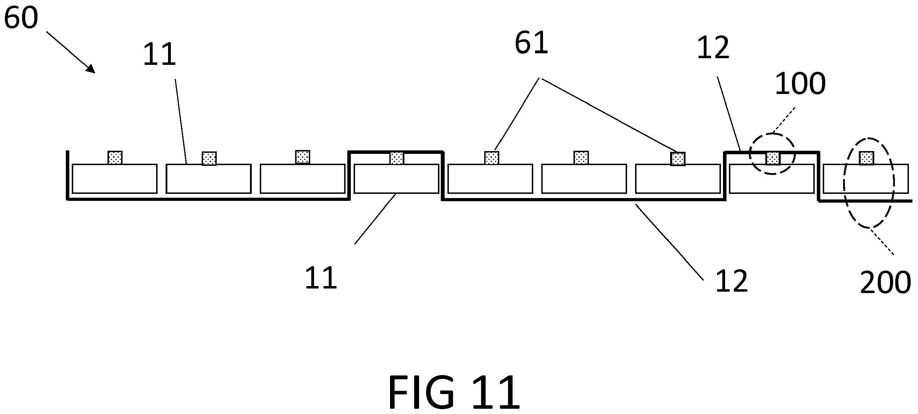

FIG 11 schematically shows a cross section of a second exemplary woven fabric 60. More in particular, FIG 11 shows a cross section along the weft direction 3, i.e. substantially orthogonal to the warp direction 2, of such a woven fabric 60. The woven fabric 60 comprises a plurality of electrically insulating ribbons 11 arranged in the warp direction, a first plurality of first electrically conductive wires or ribbons 12 arranged in the weft direction and a second plurality of second electrically conductive wires or ribbons 61 arranged in the warp direction. As illustrated in FIG 11, the width of the second electrically conductive ribbons 61 is substantially smaller than the width of the electrically insulating ribbons 11, and each one of the second plurality of second electrically conductive ribbons 61 is provided on, i.e. stacked on, e.g. coated on, and laterally aligned with, an electrically insulating ribbon 11 such that its lateral edges are not extending beyond lateral edges of the electrically insulating ribbon 11. In the woven fabric 60, the second plurality of second electrically conductive ribbons 61 is provided at a single side (at the second side or non-contact side) of the woven fabric, i.e. at a single side of the plurality of electrically insulating ribbons. The second electrically conductive wires, e.g. ribbons, 61 may be provided in the fabric by stacking them, e.g. coating them, on the electrically insulating ribbons. The first electrically conductive wires, e.g. ribbons, 12 may be secured in the woven fabric by weaving them (thereby providing them in the weft direction) with the plurality of electrically insulating ribbons 11 coated at a second side with a second electrically conductive wire or ribbons 61. As a result of weaving of the first plurality of first electrically conductive wires 12 with the plurality of electrically insulating ribbons coated at their second side with a second electrically conductive wire 61, an electrical contact or electrical connection may be formed between a first electrically conductive wire or ribbon 12 and a second electrically conductive wire or ribbon 61 at locations 100 where the first electrically conductive wire 12 is exposed at the second side of the fabric, as illustrated in FIG 11. At locations 200 where the first electrically conductive wire or ribbon 12 is exposed at a first side (contact side) of the fabric 60, an electrically insulating ribbon 11 electrically insulates the second electrically conductive wire 61 from the first electrically conductive wire 12 provided on the electrically insulating ribbon, and at such locations 200 no electrical contact is formed between the first and second electrically conductive ribbons. This is illustrated in FIG 11.

In advantageous embodiments of the present invention, as for example illustrated in FIG 6, a twill fabric may be used wherein the first electrically conductive wires 12 are woven in pairs 122 into the fabric 60, i.e. wherein pairs 122 of first electrically conductive wires are woven into the fabric, each pair 122 comprising two first electrically conductive wires 12 woven side by side (next to each other but with a lateral spacing in between) into the fabric 60 according to the same pattern (i.e. passing over and under the same warp oriented ribbons). In such advantageous embodiments the two first electrically conductive wires of each pair 122 may be electrically connected to a same, single, second electrically conductive wire 61, e.g. at two locations 100 (FIG 11), and the second electrically conductive wire 61 may be interrupted between both these locations 100 to electrically insulate the first electrically conductive wires from the same pair from each other. Interrupting of the second electrically conductive wire may for example be obtained by punching or cutting a hole 15 through the second electrically conductive wire. As a result of this interrupting, e.g. hole punching or hole cutting, the second electrically conductive wire comprises, e.g. is divided into, at least a first segment and a second segment that are electrically insulated from each other.

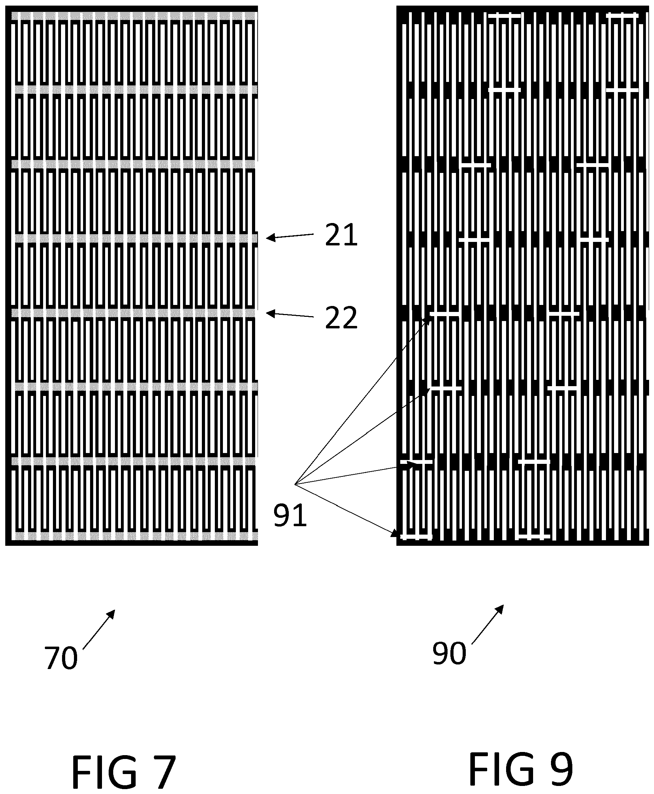

FIG 7 illustrates, schematically, a back surface of an exemplary interdigitated back-contact photovoltaic cell 70, for use in combination with an exemplary woven fabric 60 in accordance with embodiments of the present invention as shown in FIG 6. The back-contact photovoltaic cell 70 comprises, on the surface for contacting the woven fabric, e.g. on the rear surface opposite of the front surface for being oriented to a source of illumination in operation of the cell, at least one first metal contact 21 and at least one second metal contact 22 of opposite polarity with respect to the first metal contact. For example, a plurality of first metal contacts 21 may consist of first busbars and a plurality of first fingers electrically connected thereto for connecting to a first polarity, and the plurality of second metal contacts 22 may consist of second busbars and a plurality of second fingers electrically connected thereto for connecting to the opposite polarity, wherein the plurality of first fingers are interdigitated with the plurality of second fingers. However, embodiments of the present invention are not necessarily limited to IBC cells comprising busbar structures. As will be explained in detail further hereinbelow, the woven fabric 60 may be used to locally form busbar structures connecting directly to first and second contacts formed by the cell finger structures.

The woven fabric 60 comprises a plurality of electrically insulating ribbons 11 arranged in a warp direction 2 of the woven fabric. The woven fabric 60 also comprises a first plurality of first electrically conductive wires 12, arranged in the weft direction 3 of the woven fabric and a second plurality of second electrically conductive wires 61 arranged in a warp direction 2 of the woven fabric. For example, for each electrically insulating ribbon 11, a second electrically conductive wire 61 may be provided on top of the insulating ribbon, e.g. arranged substantially along a central longitudinal axis thereof and in direct physical contact with the insulating ribbon at the 'non-contact' side thereof, e.g. at the side of the insulating ribbon that is intended to face away from the back-contact photovoltaic cell 70. Thus, where a first electrically conductive wire from the first plurality of first conductive wires 12 is woven below an insulating ribbon 11, no contact is established between warp and weft conductive wires, e.g. due to the warp and weft wires being separated by the insulating ribbon, while where a first electrically conductive wire from the first plurality of first conductive wires 12 is woven above the insulating ribbon 11, an electrical contact may be established between warp and weft conductive wires. This is illustrated in FIG 11.

For example, the second plurality of second conductive wires 61 may be provided to form cell-to-cell interconnections in a cell string, while the first plurality of first conductive wires 12 may be provided to form an electrical connection to metal contacts 21, 22 of the back-contact photovoltaic cell 70 and to form an electrical connection to a segment of a second conductive wire of the second plurality of second conductive wires 61. Furthermore, the first plurality of first conductive wires 12 may provide interconnections between a plurality of cell strings, e.g. for interconnecting two cell strings.

The woven fabric 60 may be a twill or twill-like weave fabric, the present invention not being limited thereto. This twill or twill-like pattern may advantageously implement a tapering design, as will be described hereinbelow. Furthermore, in this twill or twill-like weave fabric, at least two, e.g. two, conductive wires of the first plurality of first conductive wires 12 may be weft per pick, e.g. such as to provide pairs of adjacent first conductive wires in the weft direction that are aligned with respect to the weave pattern. Furthermore, the woven fabric 60 may be a twill weave pattern with double weft first conducting wires 12, and may be identified by a twill ratio of x/y, where x, the number of harnesses lifted in the loom, equals the number of busbars of same polarity on the photovoltaic cell minus one, and where y, the number of harnesses lowered in the loom, equals 1. For example, as shown in FIG 6, a 3/1 warp-face twill, e.g. 1 up and 3 down, of double weft first conductive wires may be provided.

For example, the first plurality of first conductive wires 12 may be woven such that a twill pattern exposes a first conductive wire of the first plurality of first conductive wires 12 at a surface for contacting the back-contact photovoltaic cell at a first predetermined location 16 corresponding to a location of the first metal contact 21 on the back-contact photovoltaic cell 70, and for exposing another one first conductive wire of the first plurality of first conductive wires 12 at this surface for contacting at a second predetermined location 17 corresponding to a location of the second metal contact 22. This pair 122 of first conductive wires may be adjacent, e.g. neighbouring first conductive wires in the weft direction, i.e. they may form a pair 122 of first electrically conductive wires. This pair 122 of first electrically conductive wires 12 may furthermore be aligned with respect to the weave pattern, e.g. may correspond to a single pick of double weft first conductive wires. Where both first conductive wires cross over a common insulating ribbon, e.g. due to their aligned weave, an electrical connection would be established between the first metal contact 21 and the second metal contact 22 via the first and second conductive wires. However, an electrical interruption, e.g. a hole 15, in between the double weft first conductive wires, is provided in the second conductive wire 61 in the warp direction to electrically insulate the first metal contact 21 and the second metal contact 22 from each other.

At least one of, e.g. most of or each of, the second plurality of second electrically conductive wires 61 comprises at least a first segment 13 and a second segment 14 that are electrically insulated from each other, e.g. by a hole 15 separating the first segment 13 from the second segment 14. For example, most of, e.g. each of, the second plurality of second conductive wires 61 may be severed or interrupted by a corresponding hole 15 provided through the second conductive wire 61 and the insulating ribbon 11 directly underneath. Such hole may be provided by stamping or locally cutting the second conductive wire 61, e.g. stamping or cutting the second conductive wire and the overlapping part of the insulating ribbon. However, preferably, the width of the hole 15 may be smaller than the width of the insulating ribbon, e.g. such as to maintain a structural integrity provided by the warp oriented ribbon.

Such electrical interruption, e.g. such hole 15, may be provided at a location in between the locations where the respective first conductive ribbons or wires 12 of a pair 122 of first conductive wires for contacting the back-contact photovoltaic cell at respectively the first predetermined location 16 and the second predetermined location 17 cross over at least one insulating ribbon 11, e.g. over the same insulating ribbon, such that the first segment 13 electrically connects to one first conductive wire of this pair 122, and the second segment 14 electrically connects to the other one first conductive wire of this pair 122.

Thus, a hole 15, or a different type of electrical interruption for at least electrically disconnecting the first segment from the second segment, may be provided through the second electrically conductive wire 61 in between the first conductive wires 12 of the pair 122 of aligned weft first electrically conductive wires 12.

The electrical interruptions, e.g. holes 15, may be provided in each second electrically conductive wire 61 at a fixed position with respect to the twill-like weave pattern, e.g. in a fixed pick of the pick sequence. Due to a fixed offset of the weave pattern, e.g. the pick pattern, in one first conductive wire pair with respect to a next first conductive wire pair, the electrical interruptions may form a tapered structure in the woven fabric. For example, each second electrically conductive wire 61 may comprise a segment for contacting a negative polarity contact of the back-contact photovoltaic cell at one end and a segment for contacting a positive polarity contact of the back-contact photovoltaic cell at the other end.

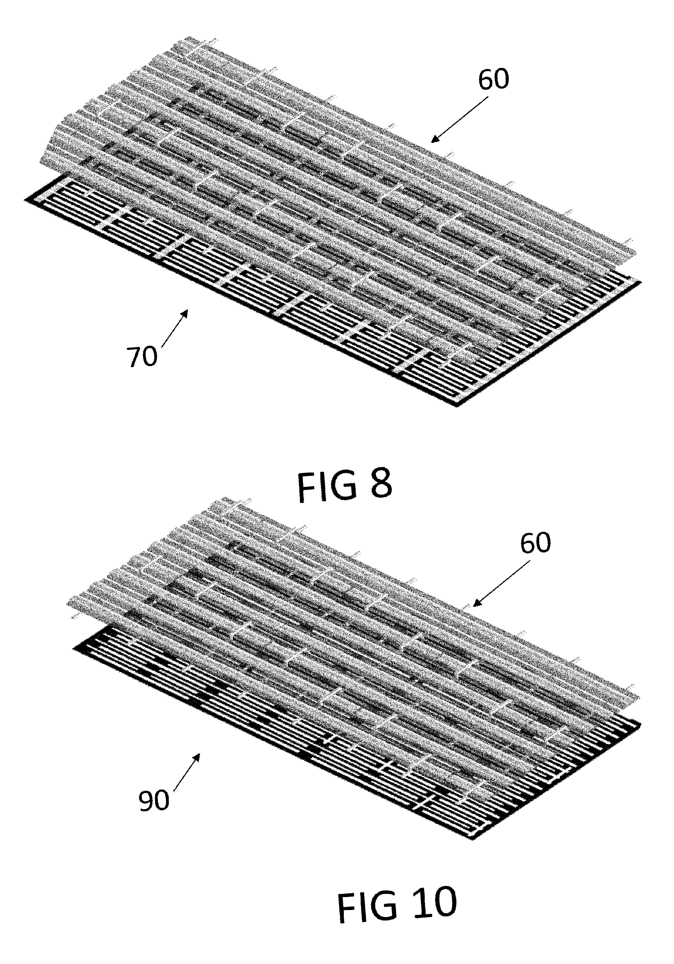

The step of bringing the woven fabric 60 into physical contact with a surface of the at least one back-contact photovoltaic cell 70, e.g. with the back side of an interdigitated back-contact photovoltaic cell 70, is illustrated in FIG 8. A method in accordance with embodiments of the present invention may comprise aligning the at least one back-contact photovoltaic cell 70 and the woven fabric 60, e.g. prior to bringing the woven fabric into contact with the back-contact photovoltaic cell, such as to align the first predetermined location 16 with a location of the first metal contact 21 on the back-contact photovoltaic cell 70, and to align the second predetermined location 17 with a location of the second metal contact 22.

Thus, after contacting, first segments 13 of the second electrically conductive wires 61 may be electrically connected to the back-contact photovoltaic cells to carry a first charge polarity, e.g. connected to '-' terminals, and second segments 14 of the second electrically conductive wires 61 may be electrically connected to the back-contact photovoltaic cells to carry a second charge polarity opposite to the first charge polarity, e.g. connected to '+' terminals.

Then, the back-contact photovoltaic cell or a plurality of back-contact photovoltaic cells 70 may be provided on, e.g. laid on, a transparent front carrier such as a glass plate, with a front side of the photovoltaic cells being oriented towards the front carrier, the woven fabric 60 may be provided on, e.g. laid on, the photovoltaic cells and aligned with the photovoltaic cells, and a back carrier, e.g. a further glass plate or backsheet, may be provided on, e.g. laid on, the woven fabric, in view of forming an encapsulated photovoltaic module. In between the transparent front carrier and the photovoltaic cells an encapsulant, e.g. a transparent encapsulant, may be provided. In between the back carrier and the photovoltaic cells, the material of the insulating ribbons of the woven fabric 60 may function as an encapsulant. The amount of encapsulation material provided by the insulating ribbons 11 may be sufficient, i.e. there may be no need for providing additional encapsulation material or an additional encapsulation layer. Next a heating process is performed, thereby transforming the material of the electrically insulating ribbons into an encapsulant layer, e.g. by liquefying the insulating ribbons. Simultaneously, by performing the heating process in a method in accordance with embodiments of the present invention, the back-contact photovoltaic cells 70 are electrically connected and physically bonded to the woven fabric 60.

This exemplary method and a woven fabric 60 associated therewith can be advantageously used to connect busbar-less interdigitated back-contact photovoltaic cells. For example, FIG 9 shows a busbar-less interdigitated back-contact photovoltaic cell 90. The cell-level busbar function may be replaced by the first plurality of first conductive wires 12 in the woven fabric 60, e.g. by directly soldering the contact-side exposed wires of the first plurality of first conductive wires 12 on the cell fingers. In such approach, fingers may be joined by a local metal connection on the back-contact photovoltaic cell 90 at locations 91 where the first plurality of first conductive wires are not exposed at the contact-side of the woven fabric, as shown by the alignment and contacting steps depicted in FIG 10.

## Claims

1. A method for contacting and electrically connecting at least one back-contact photovoltaic cell, the method comprising:
- providing at least one back-contact photovoltaic cell (20;70;90), wherein said at least one back-contact photovoltaic cell comprises at least a first metal contact (21) of a first polarity and a second metal contact (22) of a second, opposite polarity on a single surface thereof;
- providing a woven fabric (10;60) comprising a plurality of insulating ribbons (11) arranged in only a single one direction selected from the group consisting of a warp direction (2) and a weft direction (3) of the woven fabric, and a plurality of conductive wires (12, 61) arranged in a weft direction (3) or a warp direction (2) or both of the woven fabric, the direction of arrangement of a first plurality of first conductive wires (12) of the plurality of wires being different from the direction of arrangement of the plurality of insulating ribbons, wherein at least one of the plurality of conductive wires (12, 61) comprises at least a first segment (13) and a second segment (14) that are electrically isolated from each other;
- bringing the woven fabric (10;60) into physical contact with said surface of the at least one back-contact photovoltaic cell (20;70;90);
- performing a heating process to establish an electrical connection between the first metal contact (21) and the first segment (13) and to establish an electrical connection between the second metal contact (22) and the second segment (14), wherein this heating process furthermore liquefies the plurality of insulating ribbons (11) to transform the plurality of insulating ribbons into an encapsulation layer.

2. The method of claim 1, wherein said plurality of conductive wires (12, 61) of the woven fabric (10; 60) comprises copper ribbons coated with a solder material.

3. The method of any of the previous claims, wherein providing the woven fabric (10;60) comprises providing holes (15) in the woven fabric for locally interrupting the at least one of the plurality of conductive wires (12, 61) comprising at least the first segment (13) and the second segment (14), to thereby electrically disconnect the at least one first segment (13) from the at least one second segment (14).

4. The method of any of the previous claims, wherein providing the at least one back-contact photovoltaic cell (20) comprises providing a plurality of emitter wrap-through photovoltaic cells and/or a plurality of metal wrap-through photovoltaic cells and wherein the first plurality of first conductive wires (12) comprises each of the at least one of the plurality of conductive wires comprising at least the first segment and the second segment.

5. The method of claim 4, wherein the first plurality of first conductive wires (12) of the woven fabric (10) is provided such that a weave pattern exposes each one of said first conductive wires (12) comprising at least the first segment and the second segment at a first predetermined location (16) and at a second predetermined location (17), the first predetermined location (16) corresponding to a location of a metal contact (21) of the first polarity on the single surface of one of the plurality of back-contact photovoltaic cells and the second predetermined location (17) corresponding to a location of a metal contact (22) of the second polarity on the single surface of another one of the plurality of back-contact photovoltaic cells, wherein each one of said first conductive wires comprising at least the first segment and the second segment is exposed at both the first predetermined location (16) and the second predetermined location (17) on a surface of the woven fabric for contacting the back-contact photovoltaic cells.

6. The method of claim 5, wherein each one of said first conductive wires (12) comprising at least the first segment and the second segment crosses over at least one insulating ribbon of the plurality of insulating ribbons (11) in between the first predetermined location (16) and the second predetermined location (17) to be exposed at a surface of the woven fabric opposite of the surface for contacting the back-contact photovoltaic cells.

7. The method of claim 6, in which said first segment (13) of the at least one conductive wire comprising at least the first segment and the second segment comprises the first predetermined location (17) and said second segment (14) of the at least one conductive wire comprising at least the first segment and the second segment comprises the second predetermined location (18), and wherein said first segment (13) and said second segment (14) are disconnected from each other by a hole (15) interrupting the at least one conductive wire (12) comprising at least the first segment and the second segment, the hole (15) being provided where said at least one conductive wire (12) comprising at least the first segment and the second segment crosses over the at least one insulating ribbon of the plurality of insulating ribbons (11) in between the first predetermined location (16) and the second predetermined location (17).

8. The method of any of the claims 4 to 7, wherein the woven fabric (10) comprises two string end busbars interwoven at opposite ends of the first plurality of first conductive wires (12), each string end busbar comprising a further conductive wire arranged on, and oriented along a corresponding one of the plurality of insulating ribbons (11), such that electrical contacts are established between the first segments (13) of the at least one conductive wire comprising at least the first segment and the second segment and the first string end busbar (51) and electrical contacts are established between the second segments (14) of the at least one conductive wire comprising at least the first segment and the second segment and the second string end busbar (52).

9. The method of any of the claims 1 to 3, wherein providing the at least one back-contact photovoltaic cell (70;90) comprises providing a plurality of interdigitated back-contact photovoltaic cells and wherein a second plurality of second conductive wires (61) of the plurality of conductive wires is arranged in the direction of the plurality of insulating ribbons (11), each one of the second plurality of second conductive wires (61) being arranged on a corresponding one of the plurality of insulating ribbons (11) and being oriented along a central longitudinal axis thereof.

10. The method of claim 9, wherein the woven fabric (60) comprises a weave pattern in which at least part of the first plurality of first conductive wires (12) is double weft per pick such as to form a plurality of aligned pairs (122) of first conductive wires

11. The method of claim 10, wherein for at least one pair of the plurality of aligned pairs (122) of first conductive wires, the weave pattern exposes, on a surface of the woven fabric for contacting the back-contact photovoltaic cells, one of the first conductive wires of that pair at a first predetermined location (16), corresponding to a location of the first metal contact (21) on the single surface one of the plurality of back-contact photovoltaic cells, and exposes the other one of the first conductive wires of that pair at a second predetermined location (17), corresponding to a location of the second metal contact (22) on the single surface of the same one of the plurality of back-contact photovoltaic cells.

12. The method of claim 11, wherein the first conductive wires of said at least one pair of the plurality of aligned pairs (122) of first conductive wires cross over a same one of the plurality of insulating ribbons (11) and its corresponding second conductive wire of the second plurality of second conductive wires (61) to form electrical connections between respectively one of the conductive wires of said at least one pair of the plurality of aligned pairs (122) of first conductive wires (12) and said first segment (13) and said other one of the conductive wires (12) of said at least one pair of the plurality of aligned pairs (122) of first conductive wires (12) and said second segment (14), wherein the first segment (13) and the second segment (14) are segments of said corresponding second conductive wire of the second plurality of second conductive wires (61).

13. The method of claim 12, in which said first segment (13) and said second segment (14) of said corresponding second conductive wire of the second plurality of second conductive wires (61) are disconnected from each other by a hole (15) interrupting said corresponding second conductive wire of the second plurality of second conductive wires (61), the hole (15) being provided in between said first conductive wires of said at least one pair of the plurality of aligned pairs (122) of first conductive wires (12).

14. A woven fabric (10;60) for use in a method according to any of claims 1 to 13, the woven fabric comprising a plurality of insulating ribbons (11) arranged in only a single one direction selected from the group of a warp direction (2) and a weft direction (3) of the woven fabric, and a plurality of conductive wires (12, 61), arranged in a weft direction (3) or a warp direction (2) or both of the woven fabric, the direction of arrangement of a first plurality of first conductive wires (12) of the plurality of wires being different from the direction of arrangement of the plurality of insulating ribbons, wherein at least one of the plurality of conductive wires (12, 61) comprises at least a first segment (13) and a second segment (14) that are electrically isolated from each other.

15. A photovoltaic module comprising a plurality of back-contact photovoltaic cells (20; 70; 90) and a woven fabric (10; 60) according to claim 14,
wherein each of said plurality of back-contact photovoltaic cells comprises at least a first metal contact (21) of a first polarity and a second metal contact (22) of a second, opposite polarity on a single surface thereof,
wherein said plurality of back-contact photovoltaic cells are contacted and electrically connected by said woven fabric (10; 60),
wherein said woven fabric is in physical contact with said surfaces of the plurality of back-contact photovoltaic cells (20; 70; 90),
wherein an electrical connection between the first metal contact (21) and the first segment (13) and an electrical connection between the second metal contact (22) and the second segment (14) are established,
wherein the plurality of insulating ribbons are at least partially molten over an area of physical contact between said woven fabric and said surfaces of the plurality of back-contact photovoltaic cells to form an encapsulation layer.

## Patentansprüche

1. Ein Verfahren zum Kontaktieren und elektrischen Verbinden mindestens einer Rückseitenkontakt-Photovoltaikzelle, wobei das Verfahren umfasst:
- Bereitstellen mindestens einer Rückseitenkontakt-Photovoltaikzelle (20;70;90), wobei die mindestens eine Rückseitenkontakt-Photovoltaikzelle mindestens einen ersten Metallkontakt (21) einer ersten Polarität und einen zweiten Metallkontakt (22) einer zweiten entgegengesetzten Polarität an einer einzelnen Oberfläche davon umfasst;
- Bereitstellen eines Gewebes (10;60), das eine Vielzahl von isolierenden Bändern (11) umfasst, die in nur einer einzelnen Richtung angeordnet sind, die aus der Gruppe ausgewählt ist, bestehend aus einer Kettrichtung (2) und einer Schussrichtung (3) des Gewebes, und eine Vielzahl von leitfähigen Drähten (12, 61), die in einer Schussrichtung (3) oder einer Kettrichtung (2) oder beidem des Gewebes angeordnet sind, wobei die Anordnungsrichtung einer ersten Vielzahl von ersten leitfähigen Drähten (12) der Vielzahl von Drähten sich von der Anordnungsrichtung der Vielzahl von isolierenden Bändern unterscheidet, wobei mindestens einer der Vielzahl von leitfähigen Drähten (12, 61) mindestens ein erstes Segment (13) und ein zweites Segment (14) umfasst, die elektrisch voneinander isoliert sind;
Bringen des Gewebes (10;60) in physischen Kontakt mit der Oberfläche der mindestens einen Rückseitenkontakt-Photovoltaikzelle (20;70;90);
Durchführen eines Heizprozesses, um eine elektrische Verbindung zwischen dem ersten Metallkontakt (21) und dem ersten Segment (13) herzustellen und eine elektrische Verbindung zwischen dem zweiten Metallkontakt (22) und dem zweiten Segment (14) herzustellen, wobei dieser Heizprozess darüber hinaus die Vielzahl von isolierenden Bändern (11) verflüssigt, um die Vielzahl von isolierenden Bändern in eine Einkapselungsschicht umzuwandeln.

2. Das Verfahren nach Anspruch 1, wobei die Vielzahl von leitfähigen Drähten (12, 61) des Gewebes (10; 60) Kupferbänder umfasst, die mit einem Lötmaterial beschichtet sind.

3. Das Verfahren nach einem der vorstehenden Ansprüche, wobei Bereitstellen des Gewebes (10;60) Bereitstellen von Löchern (15) in dem Gewebe zum lokalen Unterbrechen des mindestens einen der Vielzahl von leitfähigen Drähten (12, 61) umfasst, der mindestens das erste Segment (13) und das zweite Segment (14) umfasst, um dadurch das mindestens eine erste Segment (13) elektrisch von dem mindestens einen zweiten Segment (14) zu trennen.

4. Das Verfahren nach einem der vorstehenden Ansprüche, wobei Bereitstellen der mindestens einen Rückseitenkontakt-Photovoltaikzelle (20) Bereitstellen einer Vielzahl von Emitter Wrap-Through Photovoltaikzellen und/oder einer Vielzahl von Metall Wrap-Through Photovoltaikzellen umfasst und wobei die erste Vielzahl von ersten leitfähigen Drähten (12) jeden des mindestens einen der Vielzahl von leitfähigen Drähten umfasst, die mindestens das erste Segment und das zweite Segment umfassen.

5. Das Verfahren nach Anspruch 4, wobei die erste Vielzahl von ersten leitfähigen Drähten (12) des Gewebes (10) derart bereitgestellt ist, dass eine Webstruktur jeden der ersten leitfähigen Drähte (12), der mindestens das erste Segment und das zweite Segment umfasst, bei einer ersten vorgegebenen Stelle (16) und bei einer zweiten vorgegebenen Stelle (17) freilegt, wobei die erste vorgegebene Stelle (16) einer Stelle eines Metallkontakts (21) der ersten Polarität auf der einzelnen Oberfläche einer der Vielzahl von Rückseitenkontakt-Photovoltaikzellen entspricht und die zweite vorgegebene Stelle (17) einer Stelle eines Metallkontakts (22) der zweiten Polarität auf der einzelnen Oberfläche einer anderen der Vielzahl von Rückseitenkontakt-Photovoltaikzellen entspricht, wobei jeder der ersten leitfähigen Drähte mindestens das erste Segment umfasst und das zweite Segment sowohl an der ersten vorgegebenen Stelle (16) als auch der zweiten vorgegebenen Stelle (17) auf einer Oberfläche des Gewebes freigelegt ist, um die Rückseitenkontakt-Photovoltaikzellen zu kontaktieren.

6. Das Verfahren nach Anspruch 5, wobei jeder der ersten leitfähigen Drähte (12) mindestens das erste Segment umfasst und das zweite Segment über mindestens ein isolierendes Band der Vielzahl von isolierenden Bändern (11) zwischen der ersten vorgegebenen Stelle (16) und der zweiten vorgegebenen Stelle (17) quert, um bei einer Oberfläche des Gewebes entgegen der Oberfläche zum Kontaktieren der Rückseitenkontakt-Photovoltaikzellen freigelegt zu werden.

7. Das Verfahren nach Anspruch 6, in dem das erste Segment (13) des mindestens einen leitfähigen Drahts mindestens das erste Segment umfasst und das zweite Segment die erste vorgegebene Stelle (17) umfasst, und das zweite Segment (14) des mindestens einen leitfähigen Drahts mindestens das erste Segment umfasst und das zweite Segment die zweite vorgegebene Stelle (18) umfasst, und wobei das erste Segment (13) und das zweite Segment (14) durch ein Loch (15) voneinander getrennt sind, das den mindestens einen leitfähigen Draht (12) unterbricht, der mindestens das erste Segment und das zweite Segment umfasst, wobei das Loch (15) bereitgestellt wird, wo der mindestens eine leitfähige Draht (12) mindestens das erste Segment umfasst und das zweite Segment über das mindestens eine isolierende Band der Vielzahl von isolierenden Bändern (11) zwischen der ersten vorgegebenen Stelle (16) und der zweiten vorgegebenen Stelle (17) quert.

8. Das Verfahren nach einem der Ansprüche 4 bis 7, wobei das Gewebe (10) zwei Drahtendsammelschienen umfasst, die an entgegengesetzten Enden der ersten Vielzahl von ersten leitfähigen Drähten (12) verwoben sind, wobei jede Drahtendsammelschiene einen weiteren leitfähigen Draht an einem entsprechenden der Vielzahl von isolierenden Bändern (11) angeordnet und entlang davon ausgerichtet umfasst, sodass elektrische Kontakte zwischen den ersten Segmenten (13) des mindestens einen leitfähigen Drahts, der mindestens das erste Segment und das zweite Segment umfasst, und der ersten Drahtendsammelschiene (51) hergestellt werden und elektrische Kontakte zwischen den zweiten Segmenten (14) des mindestens einen leitfähigen Drahts, der mindestens das erste Segment und das zweite Segment umfasst, und der zweiten Drahtendsammelschiene (52) hergestellt werden.

9. Das Verfahren nach einem der Ansprüche 1 bis 3, wobei Bereitstellen der mindestens einen Rückseitenkontakt-Photovoltaikzelle (70;90) Bereitstellen einer Vielzahl von verzahnten Rückseitenkontakt-Photovoltaikzellen umfasst und wobei eine zweite Vielzahl von zweiten leitfähigen Drähten (61) der Vielzahl von leitfähigen Drähten in der Richtung der Vielzahl von isolierenden Bändern (11) angeordnet ist, wobei jeder der zweiten Vielzahl von zweiten leitfähigen Drähten (61) auf einem entsprechenden der Vielzahl von isolierenden Bändern (11) angeordnet ist und entlang einer Mittellängsachse davon ausgerichtet ist.

10. Das Verfahren nach Anspruch 9, wobei das Gewebe (60) eine Webstruktur umfasst, in der mindestens Teil der ersten Vielzahl von ersten leitfähigen Drähten (12) pro Aufnahme doppelt geschossen wird, um eine Vielzahl von ausgerichteten Paaren (122) von ersten leitfähigen Drähten zu bilden.

11. Das Verfahren nach Anspruch 10, wobei für mindestens ein Paar der Vielzahl von ausgerichteten Paaren (122) von ersten leitfähigen Drähten die Webstruktur auf einer Oberfläche des Gewebes, um die Rückseitenkontakt-Photovoltaikzellen zu kontaktieren, einen der ersten leitfähigen Drähte dieses Paares bei einer ersten vorgegebenen Stelle (16), entsprechend einer Stelle des ersten Metallkontakts (21) auf der einzelnen Oberfläche einer der Vielzahl von Rückseitenkontakt-Photovoltaikzellen freilegt, und den anderen der ersten leitfähigen Drähte dieses Paares bei einer zweiten vorgegebenen Stelle (17), entsprechend einer Stelle des zweiten Metallkontakts (22) auf der einzelnen Oberfläche derselben der Vielzahl von Rückseitenkontakt-Photovoltaikzellen freilegt.

12. Das Verfahren nach Anspruch 11, wobei die ersten leitfähigen Drähte des mindestens einen Paares der Vielzahl von ausgerichteten Paaren (122) erster leitfähiger Drähte über selbe der Vielzahl von isolierenden Bänder (11) und deren entsprechenden zweiten leitfähigen Draht der zweiten Vielzahl von zweiten leitfähigen Drähten (61) queren, um elektrische Verbindungen zwischen jeweiligen der leitfähigen Drähte des mindestens einen Paares der Vielzahl von ausgerichteten Paaren (122) erster leitfähiger Drähte (12) und dem ersten Segment (13) und dem anderen der leitfähigen Drähte (12) des mindestens einen Paares der Vielzahl von ausgerichteten Paaren (122) erster leitfähiger Drähte (12) und dem zweiten Segment (14) zu bilden, wobei das erste Segment (13) und das zweite Segment (14) Segmente des entsprechenden zweiten leitfähigen Drahts der zweiten Vielzahl von zweiten leitfähigen Drähten (61) sind.

13. Das Verfahren nach Anspruch 12, in dem das erste Segment (13) und das zweite Segment (14) des entsprechenden zweiten leitfähigen Drahts der zweiten Vielzahl von zweiten leitfähigen Drähten (61) durch ein Loch (15) voneinander getrennt sind, das den entsprechenden zweiten leitfähigen Draht der zweiten Vielzahl von zweiten leitfähigen Drähten (61) unterbricht, wobei das Loch (15) zwischen den ersten leitfähigen Drähten des mindestens einen Paares der Vielzahl von ausgerichteten Paaren (122) erster leitfähiger Drähte (12) bereitgestellt ist.

14. Ein Gewebe (10;60) zur Verwendung in einem Verfahren nach einem der Ansprüche 1 bis 13, wobei das Gewebe eine Vielzahl von isolierenden Bändern (11) umfasst, die in nur einer einzelnen Richtung angeordnet sind, ausgewählt aus der Gruppe aus einer Kettrichtung (2) und einer Schussrichtung (3) des Gewebes, und eine Vielzahl von leitfähigen Drähten (12, 61), die in einer Schussrichtung (3) oder einer Kettrichtung (2) oder beiden des Gewebes angeordnet sind, wobei die Anordnungsrichtung einer ersten Vielzahl von ersten leitfähigen Drähten (12) der Vielzahl von Drähten sich von der Anordnungsrichtung der Vielzahl von isolierenden Bändern unterscheidet, wobei mindestens einer der Vielzahl von leitfähigen Drähten (12, 61) mindestens ein erstes Segment (13) und ein zweites Segment (14) umfasst, die elektrisch voneinander isoliert sind.

15. Ein Photovoltaikmodul, das eine Vielzahl von Rückseitenkontakt-Photovoltaikzellen (20; 70; 90) und ein Gewebe (10; 60) nach Anspruch 14 umfasst,
- wobei jede der Vielzahl von Rückseitenkontakt-Photovoltaikzellen mindestens einen ersten Metallkontakt (21) einer ersten Polarität und einen zweiten Metallkontakt (22) einer zweiten entgegengesetzten Polarität auf einer einzelnen Oberfläche davon umfasst,
- wobei die Vielzahl von Rückseitenkontakt-Photovoltaikzellen von dem Gewebe (10; 60) kontaktiert und elektrisch davon verbunden werden,
- wobei das Gewebe in physischem Kontakt mit den Oberflächen der Vielzahl von Rückseitenkontakt-Photovoltaikzellen (20; 70; 90) ist,
- wobei eine elektrische Verbindung zwischen dem ersten Metallkontakt (21) und dem ersten Segment (13) und eine elektrische Verbindung zwischen dem zweiten Metallkontakt (22) und dem zweiten Segment (14) hergestellt sind,
- wobei die Vielzahl von isolierenden Bändern mindestens teilweise über einem physischen Kontaktbereich zwischen dem Gewebe und den Oberflächen der Vielzahl von Rückseitenkontakt-Photovoltaikzellen geschmolzen werden, um eine Einkapselungsschicht zu bilden.

## Revendications

1. Un procédé de mise en contact et de connexion électrique d'au moins une cellule photovoltaïque à contact arrière, le procédé comprenant les étapes consistant à :
- fournir au moins une cellule photovoltaïque à contact arrière (20 ; 70 ; 90), dans lequel ladite au moins une cellule photovoltaïque à contact arrière comprend au moins un premier contact métallique (21) d'une première polarité et un second contact métallique (22) d'une seconde polarité opposée sur une surface unique de celle-ci ;
- fournir un textile tissé (10 ; 60) comprenant une pluralité de rubans isolants (11) agencés dans seulement une seule direction choisie dans le groupe consistant en une direction de chaîne (2) et une direction de trame (3) du textile tissé, et une pluralité de fils conducteurs (12, 61) agencés dans une direction de trame (3) ou une direction de chaîne (2) ou les deux du textile tissé, la direction d'agencement d'une première pluralité de premiers fils conducteurs (12) de la pluralité de fils étant différente de la direction d'agencement de la pluralité de rubans isolants, dans lequel au moins un de la pluralité de fils conducteurs (12, 61) comprend au moins un premier segment (13) et un second segment (14) qui sont électriquement isolés l'un de l'autre ;
- amener le textile tissé (10 ; 60) en contact physique avec ladite surface de la au moins une cellule photovoltaïque à contact arrière (20 ; 70 ; 90) ;
- effectuer un processus de chauffage pour établir une connexion électrique entre le premier contact métallique (21) et le premier segment (13) et pour établir une connexion électrique entre le second contact métallique (22) et le second segment (14), dans lequel ce processus de chauffage liquéfie en outre la pluralité de rubans isolants (11) pour transformer la pluralité de rubans isolants en une couche d'encapsulation.

2. Le procédé selon la revendication 1, dans lequel ladite pluralité de fils conducteurs (12, 61) du textile tissé (10 ; 60) comprend des rubans de cuivre revêtus d'un matériau de soudure.

3. Le procédé selon l'une quelconque des revendications précédentes, dans lequel la fourniture du textile tissé (10 ; 60) comprend la fourniture de trous (15) dans le textile tissé pour interrompre localement le au moins un de la pluralité de fils conducteurs (12, 61) comprenant au moins le premier segment (13) et le second segment (14), pour ainsi déconnecter électriquement le au moins un premier segment (13) du au moins un second segment (14).

4. Le procédé selon l'une quelconque des revendications précédentes, dans lequel la fourniture de la au moins une cellule photovoltaïque à contact arrière (20) comprend la fourniture d'une pluralité de cellules photovoltaïques à émetteur enveloppé et/ou d'une pluralité de cellules photovoltaïques à métal enveloppé et dans lequel la première pluralité de premiers fils conducteurs (12) comprend chacun de l'au moins un de la pluralité de fils conducteurs comprenant au moins le premier segment et le second segment.

5. Le procédé selon la revendication 4, dans lequel la première pluralité de premiers fils conducteurs (12) du textile tissé (10) est prévue de telle sorte qu'un motif de tissage expose chacun desdits premiers fils conducteurs (12) comprenant au moins le premier segment et le second segment à un premier emplacement prédéterminé (16) et à un second emplacement prédéterminé (17), le premier emplacement prédéterminé (16) correspondant à un emplacement d'un contact métallique (21) de la première polarité sur la surface unique de l'une de la pluralité de cellules photovoltaïques à contact arrière et le second emplacement prédéterminé (17) correspondant à un emplacement d'un contact métallique (22) de la seconde polarité sur la surface unique d'une autre de la pluralité de cellules photovoltaïques à contact arrière, dans lequel chacun desdits premiers fils conducteurs comprenant au moins le premier segment et le second segment est exposé à la fois au premier emplacement prédéterminé (16) et au second emplacement prédéterminé (17) sur une surface du textile tissé pour entrer en contact avec les cellules photovoltaïques à contact arrière.

6. Procédé selon la revendication 5, dans lequel chacun desdits premiers fils conducteurs (12) comprenant au moins le premier segment et le second segment croise au moins un ruban isolant de la pluralité de rubans isolants (11) entre le premier emplacement prédéterminé (16) et le second emplacement prédéterminé (17) pour être exposé à une surface du textile tissé opposée à la surface destinée à entrer en contact avec les cellules photovoltaïques à contact arrière.

7. Le procédé selon la revendication 6, dans lequel ledit premier segment (13) du au moins un fil conducteur comprenant au moins le premier segment et le second segment comprend le premier emplacement prédéterminé (17) et ledit second segment (14) du au moins un fil conducteur comprenant au moins le premier segment et le second segment comprend le second emplacement prédéterminé (18), et dans lequel ledit premier segment (13) et ledit second segment (14) sont déconnectés l'un de l'autre par un trou (15) interrompant le au moins un fil conducteur (12) comprenant au moins le premier segment et le second segment, le trou (15) étant prévu à l'endroit où ledit au moins un fil conducteur (12) comprenant au moins le premier segment et le second segment croise le au moins un ruban isolant de la pluralité de rubans isolants (11) entre le premier emplacement prédéterminé (16) et le second emplacement prédéterminé (17).

8. Le procédé selon l'une quelconque des revendications 4 à 7, dans lequel le textile tissé (10) comprend deux barres omnibus d'extrémité de chaîne entrelacées à des extrémités opposées de la première pluralité de premiers fils conducteurs (12), chaque barre omnibus d'extrémité de chaîne comprenant un autre fil conducteur agencé sur, et orienté le long d'un ruban correspondant de la pluralité de rubans isolants (11), de sorte que des contacts électriques sont établis entre les premiers segments (13) de l'au moins un fil conducteur comprenant au moins le premier segment et le second segment et la première barre omnibus d'extrémité de chaîne (51) et des contacts électriques sont établis entre les seconds segments (14) de l'au moins un fil conducteur comprenant au moins le premier segment et le second segment et la seconde barre omnibus d'extrémité de chaîne (52).

9. Le procédé selon l'une quelconque des revendications 1 à 3, dans lequel la fourniture d'au moins une cellule photovoltaïque à contact arrière (70 ; 90) comprend la fourniture d'une pluralité de cellules photovoltaïques à contact arrière interdigitées et dans lequel une seconde pluralité de seconds fils conducteurs (61) de la pluralité de fils conducteurs est agencée dans la direction de la pluralité de rubans isolants (11), chacun de la seconde pluralité de seconds fils conducteurs (61) étant agencé sur un ruban correspondant de la pluralité de rubans isolants (11) et étant orienté le long d'un axe longitudinal central de celui-ci.

10. Le procédé selon la revendication 9, dans lequel le textile tissé (60) comprend un motif de tissage dans lequel au moins une partie de la première pluralité de premiers fils conducteurs (12) est à double trame par piqûre de manière à former une pluralité de paires alignées (122) de premiers fils conducteurs.

11. Procédé selon la revendication 10, dans lequel pour au moins une paire de la pluralité de paires alignées (122) de premiers fils conducteurs, le motif de tissage expose, sur une surface du textile tissé destinée à entrer en contact avec les cellules photovoltaïques à contact arrière, l'un des premiers fils conducteurs de cette paire à un premier emplacement prédéterminé (16), correspondant à un emplacement du premier contact métallique (21) sur la surface unique de l'une de la pluralité de cellules photovoltaïques à contact arrière, et expose l'autre des premiers fils conducteurs de cette paire à un second emplacement prédéterminé (17), correspondant à un emplacement du second contact métallique (22) sur la surface unique de la même cellule de la pluralité de cellules photovoltaïques à contact arrière.

12. Le procédé selon la revendication 11, dans lequel les premiers fils conducteurs de ladite au moins une paire de la pluralité de paires alignées (122) de premiers fils conducteurs traversent un même ruban de la pluralité de rubans isolants (11) et son second fil conducteur correspondant de la seconde pluralité de seconds fils conducteurs (61) pour former des connexions électriques entre un des fils conducteurs respectivement de ladite au moins une paire de la pluralité de paires alignées (122) de premiers fils conducteurs (12) et ledit premier segment (13) et ledit autre des fils conducteurs (12) de ladite au moins une paire de la pluralité de paires alignées (122) de premiers fils conducteurs (12) et ledit second segment (14), dans lequel le premier segment (13) et le second segment (14) sont des segments dudit second fil conducteur correspondant de la seconde pluralité de seconds fils conducteurs (61).

13. Le procédé selon la revendication 12, dans lequel ledit premier segment (13) et ledit second segment (14) dudit second fil conducteur correspondant de la seconde pluralité de seconds fils conducteurs (61) sont déconnectés l'un de l'autre par un trou (15) interrompant ledit second fil conducteur correspondant de la seconde pluralité de seconds fils conducteurs (61), le trou (15) étant prévu entre lesdits premiers fils conducteurs de ladite au moins une paire de la pluralité de paires alignées (122) de premiers fils conducteurs (12).

14. Un textile tissé (10 ; 60) destiné à être utilisé dans un procédé selon l'une quelconque des revendications 1 à 13, le textile tissé comprenant une pluralité de rubans isolants (11) agencés dans seulement une seule direction choisie dans le groupe d'une direction de chaîne (2) et d'une direction de trame (3) du textile tissé, et une pluralité de fils conducteurs (12,61) agencés dans une direction de trame (3) ou une direction de chaîne (2) ou les deux du textile tissé, la direction d'agencement d'une première pluralité de premiers fils conducteurs (12) de la pluralité de fils étant différente de la direction d'agencement de la pluralité de rubans isolants, dans lequel au moins un de la pluralité de fils conducteurs (12, 61) comprend au moins un premier segment (13) et un second segment (14) qui sont électriquement isolés l'un de l'autre.

15. Un module photovoltaïque comprenant une pluralité de cellules photovoltaïques à contact arrière (20 ; 70 ; 90) et un textile tissé (10 ; 60) selon la revendication 14,
dans lequel chacune de ladite pluralité de cellules photovoltaïques à contact arrière comprend au moins un premier contact métallique (21) d'une première polarité et un second contact métallique (22) d'une seconde polarité opposée sur une surface unique de celle-ci,
dans lequel ladite pluralité de cellules photovoltaïques à contact arrière sont en contact et connectées électriquement par ledit textile tissé (10 ; 60),
dans lequel ledit textile tissé est en contact physique avec lesdites surfaces de la pluralité de cellules photovoltaïques à contact arrière (20 ; 70 ; 90),
dans lequel une connexion électrique entre le premier contact métallique (21) et le premier segment (13) et une connexion électrique entre le second contact métallique (22) et le second segment (14) sont établies,
dans lequel la pluralité de rubans isolants est au moins partiellement fondue sur une zone de contact physique entre ledit textile tissé et lesdites surfaces de la pluralité de cellules photovoltaïques à contact arrière pour former une couche d'encapsulation.
